# EUROPEAN PATENT SPECIFICATION

(11) **EP 3 848 989 B1**
(45) Date of publication and mention of the grant of the patent: **23.04.2025**
(21) Application number: 21150337.0
(22) Date of filing: 05.01.2021
(51) Int. Cl.: H10K 50/19

(54) **ORGANIC LIGHT-EMITTING DEVICE**
ORGANISCHE LICHTEMITTIERENDE VORRICHTUNG
DISPOSITIF ÉLECTROLUMINESCENT ORGANIQUE

(30) Priority: 09.01.2020 KR 20200003181
(43) Date of publication of application: 14.07.2021
(73) Proprietor: Samsung Display Co., Ltd., Yongin-si, Gyeonggi-Do 17113 (KR)
(72) Inventor: KIM, Hyeongpil, 17113 Yongin-si (KR); KIM, Wonjong, 17113 Yongin-si (KR); KIM, Hyoyeon, 17113 Yongin-si (KR); PARK, Yeongrong, 17113 Yongin-si (KR); SEO, Dongkyu, 17113 Yongin-si (KR); SHIN, Junyong, 17113 Yongin-si (KR); AN, Junghee, 17113 Yongin-si (KR); YOO, Byeongwook, 17113 Yongin-si (KR); LEE, Daeho, 17113 Yongin-si (KR); LEE, Byungseok, 17113 Yongin-si (KR); LYU, Jaejin, 17113 Yongin-si (KR)
(74) Representative: Marks & Clerk LLP

(56) References cited:
- US-A1- 2005 029 933
- US-A1- 2017 244 059
- US-A1- 2019 207 123
- US-A1- 2019 288 212

## Description

### BACKGROUND

### 1. Field

One or more aspects of embodiments of the present disclosure relate to an organic light-emitting device.

### 2. Description of Related Art

Organic light-emitting devices are self-emissive devices that produce full-color images, and also have wide viewing angles, high contrast ratios, and short response times, as well as excellent characteristics in terms of luminance, driving voltage, and/or response speed.

The organic light-emitting device may include a first electrode on a substrate, and a hole transport region, an emission layer, an electron transport region, and a second electrode, which are sequentially positioned on the first electrode. Holes provided from the first electrode may move toward the emission layer through the hole transport region, and electrons provided from the second electrode may move toward the emission layer through the electron transport region. Carriers, such as holes and electrons, recombine in the emission layer to produce excitons. These excitons transition from an excited state to a ground state, thereby generating light.

US 2017/244059 A1 discloses a light-emitting element that includes a cathode, an anode, a light-emitting layer, a first layer, a second layer, and a third layer.

US 2019/288212 A1 discloses an organic light-emitting diode device.

US 2005/029933 A1 discloses an OLED device.

### SUMMARY

One or more aspects of embodiments of the present disclosure are directed toward an organic light-emitting device having a low driving voltage, high efficiency, and long lifespan.

Additional aspects will be set forth in part in the description which follows and, in part, will be apparent from the description, or may be learned by practice of the presented embodiments of the disclosure.

According to an embodiment, provided is an organic light-emitting device including a first electrode,
a second electrode facing the first electrode,
m emission units stacked between the first electrode and the second electrode and including at least one emission layer, and
m-1 charge generating layers between two adjacent emission units among the m emission units, each of the m-1 charge generating layers including an n-type charge generating layer and a p-type charge generating layer,
wherein m is an integer of 2 or more,
at least one of the m-1 p-type charge generating layers includes a first inorganic material, wherein the first inorganic material is a compound including a post transition metal and a metalloid,
the post transition metal is at least one selected from aluminium (Al), gallium (Ga), indium (In), thallium (TI), tin (Sn), lead (Pb), flerovium (FI), bismuth (Bi), and polonium (Po),
the metalloid is at least one selected from boron (B), silicon (Si), germanium (Ge), arsenic (As), antimony (Sb), tellurium (Te), and astatine (At), and
at least one of the m-1 n-type charge generating layers includes a metal.

According to another embodiment, provided is a flat-display apparatus including a thin-film transistor including a source electrode, a drain electrode, and an activation layer; and the organic light-emitting device, wherein the first electrode of the organic light-emitting device is electrically coupled with one selected from the source electrode and the drain electrode of the thin-film transistor.

At least some of the above and other features of the invention are set out in the claims.

### BRIEF DESCRIPTION OF THE DRAWING

The above and other aspects, features, and advantages of certain embodiments of the disclosure will be more apparent from the following description taken in conjunction with the accompanying drawings, in which:
FIGS. 1-4 are schematic cross-sectional views of organic light-emitting devices according to one or more embodiments of the present disclosure;
FIG. 5 is a graph of measurement of current density (mA/cm²) according to driving voltage (V) of organic light-emitting devices manufactured according to Examples 1 to 6 and Comparative Example 1;
FIG. 6 is a graph of measurement of maximum emission wavelength of organic light-emitting devices manufactured according to Examples 1 to 6 and Comparative Example 1; and
FIGS. 7 and 8 are graphs of measurement of electrical conductivity of organic light-emitting devices manufactured according to Examples 7 to 17.
FIG. 9 is a cross-sectional view showing a light-emitting apparatus according to an embodiment of the present disclosure.

### DETAILED DESCRIPTION

Reference will now be made in more detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof. Expressions such as "at least one selected from," "one of," and "selected from," when preceding a list of elements, modify the entire list of elements and do not modify the individual elements of the list. Further, the use of "may" when describing embodiments of the present disclosure refers to "one or more embodiments of the present disclosure."

According to an embodiment, provided is an organic light-emitting device including: a first electrode;
a second electrode facing the first electrode;
m emission units stacked between the first electrode and the second electrode and including at least one emission layer; and
m-1 charge generating layers between two adjacent emission units, each of the charge generating layers including one n-type charge generating layer and one p-type charge generating layer,
wherein m is an integer of 2 or more,
at least one of the p-type charge generating layers in the number of m-1 includes a first inorganic material, wherein the first inorganic material is a compound including a post transition metal and a metalloid,
the post transition metal is at least one selected from aluminium (Al), gallium (Ga), indium (In), thallium (TI), tin (Sn), lead (Pb), flerovium (FI), bismuth (Bi), and polonium (Po),
the metalloid is at least one selected from boron (B), silicon (Si), germanium (Ge), arsenic (As), antimony (Sb), tellurium (Te), and astatine (At), and
at least one of the m-1 n-type charge generating layers includes a metal (e.g. a transition metal).

### <Evaluation Method of the work function>

The material was spin-coated on an ITO substrate to form a 50 nm thin film, and then heat-treated for 5 minutes at 200°C on a hot plate in air, and the work function was evaluated. The equipment used for the evaluation was UPS (Ultraviolet Photoelectron Spectroscopy).

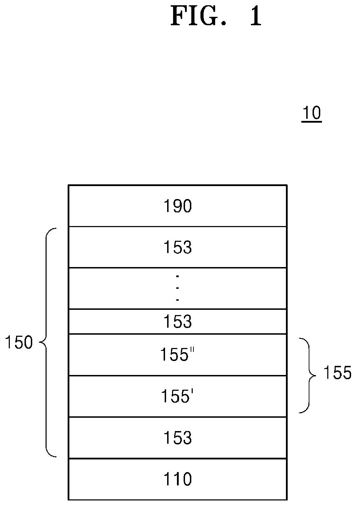

FIG. 1 is a schematic cross-sectional view of an organic light-emitting device 10 according to an embodiment. As shown in FIG. 1, the organic light-emitting device 10 according to an embodiment includes a first electrode 110, a second electrode 190 facing the first electrode 110, m emission units 153 stacked between the first electrode 110 and the second electrode 190, and m-1 charge generating layers 155 between two adjacent emission units among the m emission units 153, each of the charge generating layers 155 including one n-type charge generating layer 155' and one p-type charge generating layer 155".

An emission unit of the m emission units 153 is not particularly limited as long as the emission unit has a function capable of emitting light. For example, the emission unit includes at least one emission layer. In some embodiments, the emission unit may further include an organic layer, in addition to an emission layer.

The organic light-emitting device 10 includes m stacked emission units 153, and m is an integer of 2 or more. m (which is the number of the emission units) may be selected, as necessary, and the maximum number of the emission units is not particularly limited. For example, the organic light-emitting device may include two, three, four, or five emission units.

In one or more embodiments, a maximum emission wavelength of light emitted from at least one emission unit among the m emission units may be different from a maximum emission wavelength of light emitted from at least one emission unit among other (remaining) emission units. For example, in an organic light-emitting device in which a first emission unit and a second emission unit are stacked, a maximum emission wavelength of light emitted from the first emission unit may be different from a maximum emission wavelength of light emitted from the second emission unit. In this regard, emission layers in the first emission unit and the second emission unit may each independently include i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure having a plurality of layers including (e.g., consisting of) a plurality of different materials. Accordingly, light emitted from the first emission unit or the second emission unit may be single-color light or mixed-color light. In one or more embodiments, in an organic light-emitting device in which a first emission unit, a second emission unit, and a third emission unit are stacked, a maximum emission wavelength of light emitted from the first emission unit may be identical to a maximum emission wavelength of light emitted from the second emission unit, but may be different from a maximum emission wavelength of light emitted from the third emission unit. In some embodiments, a maximum emission wavelength of light emitted from the first emission unit, a maximum emission wavelength of light emitted from the second emission unit, and a maximum emission wavelength of light emitted from the third emission unit may be different from one another.

In one or more embodiments, maximum emission wavelengths of light respectively emitted from the m emission units may be identical to each other.

In one or more embodiments, maximum emission wavelengths of light respectively emitted from the m emission units may each independently be selected in a range of about 370 nm to about 780 nm. For example, the maximum emission wavelengths of light respectively emitted from the m emission units may each independently be selected in a range of about 370 nm to about 500 nm, about 500 nm to about 580 nm, or about 580 nm to about 780 nm.

The organic light-emitting device 10 includes a charge generating layer 155 between two adjacent emission units 153 among the m emission units 153, wherein the term "adjacent" refers to an arrangement relationship between layers that are closest to each other among layers that are described to be adjacent. For example, the two adjacent emission units refers to an arrangement relationship between two emission units that are located most closely to each other among a plurality of emission units. The "adjacent", in some cases, may refer to a case in which two layers are physically in contact with each other or a case in which another layer (that may not be described) may be located between the two layers. For example, an emission unit adjacent to a second electrode refers to, among a plurality of emission units, an emission unit that is located most closely to the second electrode. In some embodiments, the second electrode may be physically in contact with the emission unit, but in other embodiments, other layers may be located between the second electrode and the emission unit. For example, an electron transport layer may be located between the second electrode and the emission unit. However, a charge generating layer is located between two adjacent emission units.

The charge generating layer is a layer acting as a cathode with respect to one emission unit among two adjacent emission units, by generating electron(s), and an anode with respect to the other emission unit among the two adjacent emission units, by generating hole(s), and the charge generating layer refers to a layer that is not directly connected with an electrode, but that separates adjacent emission units. An organic light-emitting device including m emission units includes m-1 charge generating layers.

The charge generating layer 155 includes the n-type charge generating layer 155' and the p-type charge generating layer 155". In this regard, the n-type charge generating layer 155' and the p-type charge generating layer 155" may be in direct contact with each other to form an N-P junction. Due to the N-P junction, an electron and a hole may be simultaneously (or concurrently) generated between the n-type charge generating layer 155' and the p-type charge generating layer 155". The generated electron may be transferred, via the n-type charge generating layer 155', to one emission unit among two adjacent emission units. The generated hole may be transferred, via the p-type charge generating layer 155", to the other emission unit among the two adjacent emission units. In addition, when charge generating layers 155 each include one n-type charge generating layer 155' and one p-type charge generating layer 155", the organic light-emitting device 10 including the m-1 charge generating layers 155 may include n-type charge generating layers 155' in the number of m-1 and p-type charge generating layers 155" in the number of m-1.

The "n-type" refers to n-type semiconductor characteristics, for example, electron injection characteristics or electron transport characteristics. The "p-type" refers to p-type semiconductor characteristics, for example, hole injection characteristics or hole transport characteristics.

At least one of the p-type charge generating layers 155" in the number of m-1 includes a first inorganic material, wherein the first inorganic material is a compound including a post transition metal and a metalloid.

For example, the compound including a post transition metal and a metalloid may be an alloy including the post transition metal and the metalloid. For example, the compound including a post transition metal and a metalloid may be a compound consisting of the post transition metal and the metalloid.

In one or more embodiments, when the first inorganic material is a compound including a post transition metal and a metalloid, a composition ratio of the post transition metal and the metalloid may be from 50 : 1 to 1 : 50. For example, the composition ratio of the post transition metal and the metalloid may be from 20 : 1 to 1 : 20. For example, the composition ratio of the post transition metal and the metalloid may be from 10 : 1 to 1 : 10. For example, the composition ratio of the post transition metal and the metalloid may be from 5 : 1 to 1 : 10. For example, the composition ratio of the post transition metal and the metalloid may be from 4 : 1 to 1 : 8. For example, the composition ratio of the post transition metal and the metalloid may be from 3 : 1 to 1 : 6. For example, the composition ratio of the post transition metal and the metalloid may be from 2 : 1 to 1 : 4. For example, the composition ratio of the post transition metal and the metalloid may be from 2 : 1 to 1 : 2.

For example, an amount of the metalloid in the first inorganic material may be greater than or equal to an amount of the post transition metal in the first inorganic material.

In one or more embodiments, an absolute value of a work function of the first inorganic material may be 3.0 eV or more. For example, the absolute value of a work function of the first inorganic material may be 3.5 eV or more. For example, the absolute value of a work function of the first inorganic material may be 4.0 eV or more.

The post transition metal is at least one selected from aluminium (Al), gallium (Ga), indium (In), thallium (TI), tin (Sn), lead (Pb), flerovium (Fl), bismuth (Bi), and polonium (Po).

In one or more embodiments, the post transition metal may be at least one selected from Al, Ga, In, Tl, Sn, Pb, Fl, and Bi. In one or more embodiments, the post transition metal may be at least one selected from Al, Ga, In, Tl, Sn, Pb, and Bi.

For example, the post transition metal may be any combination of two or more selected from Al, Ga, In, Tl, Sn, Pb, Fl, and Bi, and post transition metals of any combination selected therefrom may be included in the compound including a post transition metal and a metalloid.

In one or more embodiments, the metalloid may be at least one selected from Si, Ge, As, Sb, and Te.

For example, the metalloid may be any combination of two or more selected from Si, Ge, As, Sb, and Te, and metalloids of any combination selected therefrom may be included in the compound including a post transition metal and a metalloid.

In one or more embodiments, the first inorganic material may be at least one selected from Bi₂Te₃, Bi₇Te₃, Bi₂Te, Bi₄Te₃, BiTe, Bi₆Te₇, Bi₄Te₅, BiₓTe_{y}(0<x<100, 0<y<100, 0<x+y≤100), In₂Te₃, Ga₂Te₂, Al₂Te₃, Tl₂Te₃, SnTe, PbTe, FITe, AlInSb, AlGaSb, AlAsSb, GaAs, InSb, AlSb, AlAs, AlₐInₐSb (0<a<1), Al_{b}In_{(1-b)}Sb (0<b<1), AlSb, GaSb, and AlInGaAs. For example, the first inorganic material may be at least one selected from Bi₂Te₃, Bi₇Te₃, Bi₂Te, Bi₄Te₃, BiTe, Bi₆Te₇, Bi₄Te₅, BiₓTe_{y}(0<x<100, 0<y<100, 0<x+y≤100), In₂Te₃, Ga₂Te₂, Al₂Te₃, Tl₂Te₃, SnTe, PbTe, AlInSb, AlGaSb, AlAsSb, GaAs, InSb, AlSb, AlAs, AlₐInₐSb (0<a<1), Al_{b}In_{(1-b)}Sb (0<b<1), AlSb, GaSb, and AlInGaAs.

For example, the first inorganic material may be at least one selected from Bi₂Te₃, Bi₇Te₃, Bi₂Te, Bi₄Te₃, BiTe, Bi₆Te₇, Bi₄Te₅, and BiₓTe_{y}(0<x<100, 0<y<100, 0<x+y≤100).

In one or more embodiments, a thermal evaporation temperature of the first inorganic material may be 1,500 °C or less. For example, the thermal evaporation temperature of the first inorganic material may be from 70 °C to 1,500 °C. For example, the thermal evaporation temperature of the first inorganic material may be from 70 °C to 1,000 °C. For example, the thermal evaporation temperature of the first inorganic material may be from 100 °C to 1,000 °C. For example, the thermal evaporation temperature of the first inorganic material may be from 100 °C to 700 °C. For example, the thermal evaporation temperature of the first inorganic material may be from 250 °C to 550 °C.

The n-type charge generating layers 155' include a metal and may further include a metal-free compound including at least one π electron-deficient nitrogen-containing ring, a compound represented by Formula 601, a metal oxide, a metal carbide, a metal halide, or any mixture thereof:

Formula 601 [Ar₆₀₁]ₓₑ₁₁-[(L₆₀₁)ₓₑ₁-R₆₀₁]ₓₑ₂₁.

In Formula 601,
Ar₆₀₁ is a substituted or unsubstituted C₅-C₆₀(*e*.*g*. C₅-C₃₀) carbocyclic group or a substituted or unsubstituted C₁-C₆₀ (*e*.*g*. C₁-C₂₀) heterocyclic group,
xe11 is 1, 2, or 3,
L₆₀₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₀) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
xe1 is an integer from 0 to 5,
R₆₀₁ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₀) aryl group, a substituted or unsubstituted C₆-C₆₀ (*e*.*g*. C₆-C₃₀) aryloxy group, a substituted or unsubstituted C₆-C₆₀ (*e*.*g*. C₆-C₃₀) arylthio group, a substituted or unsubstituted C₁-C₆₀ (*e*.*g*. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₆₀₁)(Q₆₀₂)(Q₆₀₃), -C(=O)(Q₆₀₁), - S(=O)₂(Q₆₀₁), and -P(=O)(Q₆₀₁)(Q₆₀₂),
Q₆₀₁ to Q₆₀₃ are each independently a C₁-C₁₀ alkyl group, a C₁-C₁₀ alkoxy group, a phenyl group, a biphenyl group, a terphenyl group, or a naphthyl group, and
xe21 is an integer from 1 to 5.

The "π electron-deficient nitrogen-containing ring" is the same as described in connection with an electron transport region described herein below.

The metal may be an alkali metal, an alkaline earth metal, a rare earth metal, a transition metal, a late transition metal, a metalloid, or any combination thereof, but embodiments of the present disclosure are not limited thereto.

In one or more embodiments, when at least one of the n-type charge generating layers 155' in the number of m-1 includes the metal oxide, the metal oxide may be an alkali metal oxide, but embodiments of the present disclosure are not limited thereto.

In one or more embodiments, when at least one of the n-type charge generating layers 155' in the number of m-1 includes the metal halide, the metal halide may be an alkali metal halide, but embodiments of the present disclosure are not limited thereto.

For example, at least one of the n-type charge generating layers 155' in the number of m-1 may include at least one selected from Yb, Ag, Al, Sm, Mg, Li, Rbl, Ti, Rb, Na, K, Ba, Mn, and YbSi₂, but embodiments of the present disclosure are not limited thereto. In one or more embodiments, at least one of the n-type charge generating layers 155' in the number of m-1 may include at least one selected from Yb, Ag, and Al, but embodiments of the present disclosure are not limited thereto.

In one or more embodiments, at least one of the p-type charge generating layers 155" in the number of m-1 may include the first inorganic material and a hole transport material.

The hole transport material is not particularly limited as long as the hole transport material is a material having hole transport characteristics, and for example, may be selected from a group represented by Formula 201, a group represented by Formula 202, and a group represented by Formula 301-2.

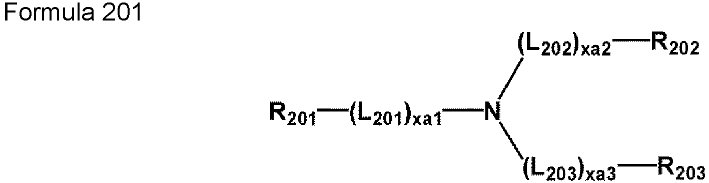

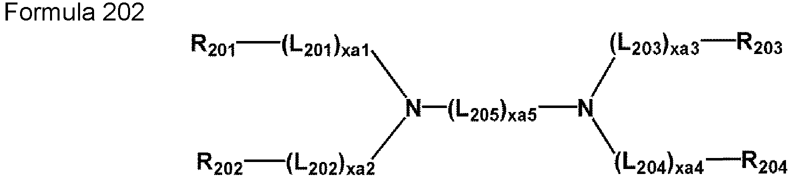

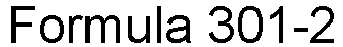

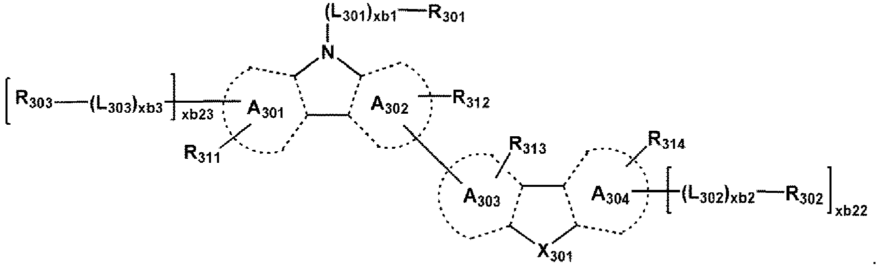

In Formulae 201, 202 and 301-2,
A₃₀₁ to A₃₀₄ are each independently selected from a benzene, a naphthalene, a phenanthrene, a fluoranthene, a triphenylene, a pyrene, a chrysene, a pyridine, a pyrimidine, an indene, a fluorene, a spiro-bifluorene, a benzofluorene, a dibenzofluorene, an indole, a carbazole, a benzocarbazole, a dibenzocarbazole, a furan, a benzofuran, a dibenzofuran, a naphthofuran, a benzonaphthofuran, a dinaphthofuran, a thiophene, a benzothiophene, a dibenzothiophene, a naphthothiophene, a benzonaphthothiophene, and a dinaphthothiophene,
X₃₀₁ is O, S, or N-[(L₃₀₄)_{xb4}-R_{304]},
L₂₀₁ to L₂₀₄ and L₃₀₁ to L₃₀₄ are each independently selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₀) arylene group, a substituted or unsubstituted C₁-C₆₀ (*e*.*g*. C₁-C₃₀) heteroarylene group, a substituted or unsubstituted divalent non-aromatic condensed polycyclic group, and a substituted or unsubstituted divalent non-aromatic condensed heteropolycyclic group,
L₂₀₅ is selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₀) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 are each independently an integer from 0 to 3,
xa5 is an integer from 1 to 10,
xb1 to xb4 are each independently an integer from 0 to 5,
xb22 and xb23 are each independently 0, 1, or 2,
R₂₀₁ to R₂₀₄ and Q₂₀₁ are each independently selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₀) aryl group, a substituted or unsubstituted C₆-C₆₀ (*e*.*g*. C₆-C₃₀) aryloxy group, a substituted or unsubstituted C₆-C₆₀ (*e*.*g*. C₆-C₃₀) arylthio group, a substituted or unsubstituted C₁-C₆₀ (*e*.*g*. C₁-C₂₀) heteroaryl group, a substituted or unsubstituted monovalent non-aromatic condensed polycyclic group, and a substituted or unsubstituted monovalent non-aromatic condensed heteropolycyclic group,
R₃₀₁ to R₃₀₄ are each independently selected from deuterium, -F, -Cl, -Br, -I, a hydroxyl group, a nitro group, an amidino group, a hydrazino group, a hydrazono group, a substituted or unsubstituted C₁-C₆₀ (*e*.*g*. C₁-C₂₀) alkyl group, a substituted or unsubstituted C₂-C₆₀ (*e*.*g*. C₂-C₂₀) alkenyl group, a substituted or unsubstituted C₂-C₆₀ (*e*.*g*. C₂-C₂₀) alkynyl group, a substituted or unsubstituted C₁-C₆₀ (*e*.*g*. C₁-C₂₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₀) aryl group, a substituted or unsubstituted C₆-C₆₀ (*e*.*g*. C₆-C₃₀) aryloxy group, a substituted or unsubstituted C₆-C₆₀ (*e.g.* C₆-C₃₀) arylthio group, a substituted or unsubstituted C₁-C₆₀ (*e*.*g*. C₁-C₂₀) heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), -B(Q₃₀₁)(Q₃₀₂), - C(=O)(Q₃₀₁), -S(=O)₂(Q₃₀₁), and -P(=O)(Q₃₀₁)(Q₃₀₂), and
R₃₁₁ to R₃₁₄ are each independently selected from hydrogen, deuterium, -F, - Cl, -Br, -I, a hydroxyl group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂),
wherein Q₃₁ to Q₃₃ and Q₃₀₁ to Q₃₀₃ are each independently selected from a C₁-C₁₀ alkyl group, a C₁-C₁₀ alkoxy group, a phenyl group, a biphenyl group, a terphenyl group, and a naphthyl group.

For example, an amount of a first inorganic material included in the p-type charge generating layer 155" may be selected in a range of 0.01 parts by weight to 49.9 parts by weight, based on 100 parts by weight of the hole transport material. For example, an amount of a first inorganic material included in the p-type charge generating layer 155" may be selected in a range of 0.1 parts by weight to 49.9 parts by weight, based on 100 parts by weight of the hole transport material. For example, an amount of a first inorganic material included in the p-type charge generating layer 155" may be selected in a range of 5 parts by weight to 20 parts by weight, based on 100 parts by weight of the hole transport material.

In one or more embodiments, a thickness of the n-type charge generating layer 155' and a thickness of the p-type charge generating layer 155" may each independently be in a range of about 5Å to about 200 Å. For example, the thickness of the n-type charge generating layer 155' and the thickness of the p-type charge generating layer 155" may each independently be in a range of about 20Å to about 200 Å, but embodiments of the present disclosure are not limited thereto. For example, the thickness of the n-type charge generating layer 155' and the thickness of the p-type charge generating layer 155" may each independently be in a range of about 20Å to about 100 Å, but embodiments of the present disclosure are not limited thereto. When the thicknesses of the n-type charge generating layer 155' and the p-type charge generating layer 155" are within any of these ranges, a high-quality (or improved) organic light-emitting device may be implemented without a substantial increase in driving voltage.

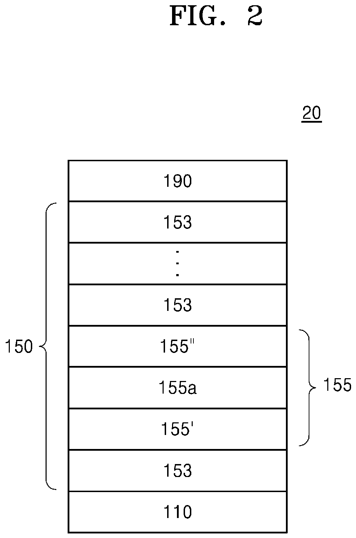

FIG. 2 is a schematic cross-sectional view of an organic light-emitting device 20 according to an embodiment.

As in FIG. 1, the organic light-emitting device 20 of FIG. 2 includes a first electrode 110, a second electrode 190 facing the first electrode 110, m emission units 153 stacked between the first electrode 110 and the second electrode 190, and m-1 charge generating layers 155 between two adjacent emission units among the m emission units 153, each of the charge generating layers 155 including one n-type charge generating layer 155' and one p-type charge generating layer 155".

In this regard, at least one of the m-1 charge generating layers 155 may further include an interlayer 155a between an n-type charge generating layer 155' and a p-type charge generating layer 155".

In one or more embodiments, the interlayer 155a may include the first inorganic material.

The first inorganic material included in the interlayer 155a is the same as described in connection with the first inorganic material described above.

For example, a first inorganic material included in at least one of the p-type charge generating layers 155" in the number of m-1 may be identical to a first inorganic material included in the interlayer 155a.

For example, a first inorganic material included in at least one of the p-type charge generating layers 155" in the number of m-1 may be different from a first inorganic material included in the interlayer 155a.

In one or more embodiments, an absolute value of a work function of the interlayer 155a may be greater than or equal to an absolute value of a work function of the n-type charge generating layer 155', and less than or equal to an absolute value of a work function of the p-type charge generating layer 155".

In one or more embodiments, when at least one of the p-type charge generating layers 155" in the number of m-1 includes the first inorganic material and a hole transport material, the organic light-emitting device 20 may include the interlayer 155a between a p-type charge generating layer 155" including the first inorganic material and the hole transport material and an n-type charge generating layer 155'.

In one or more embodiments, the organic light-emitting devices 10 and 20 may each further include a second inorganic material that is at least one selected from a halide compound of a transition metal, a halide compound of a late transition metal, and any combination thereof.

The transition metal is not particularly limited, but may be a transition metal of Group 10 to Group 12, for example, at least one selected from copper (Cu), nickel (Ni), and zinc (Zn). The late transition metal is not particularly limited, but may be at least one selected from aluminium (Al), gallium (Ga), indium (In), thallium (TI), tin(Sn), lead(Pb), flerovium (FI), bismuth (Bi), and polonium (Po).

Here, the halide compound refers to a material formed by bonding with a halogen, and the halogen may be, for example, at least one selected from F, Cl, Br, and I.

When the organic light-emitting devices 10 and 20 further include the second inorganic material, hole carriers are additionally supplied to a charge generating layer, and thus electrical characteristics/charge generation characteristics of the charge generating layer may be improved.

For example, the second inorganic material may be at least one selected from CuF, CuCl, CuBr, Cul, NiF₂, NiCl₂, NiBr₂, NiI₂, ZnF₂, ZnCl₂, ZnBr₂, ZnI₂, ZnF₄, and ZnI₄, but embodiments of the present disclosure are not limited thereto.

For example, the second inorganic material may be included in: i) a charge generating layer including a first inorganic material among the n-type charge generating layer 155' and the p-type charge generating layer 155";
ii) an auxiliary layer adjacent to the charge generating layer including a first inorganic material; or
iii) the charge generating layer including a first inorganic material and the auxiliary layer.

In this regard, the auxiliary layer may be in a form of a single layer including (e.g., consisting of) the second inorganic material.

For example, the organic light-emitting device 20 includes the interlayer 155a including the first inorganic material and may further include an auxiliary layer (not shown) including the second organic material between the interlayer 155a and the n-type charge generating layer 155' or the interlayer 155a and the p-type charge generating layer 155". In this regard, among the n-type charge generating layer 155' and the p-type charge generating layer 155", a charge generating layer including a first inorganic material may further include the second inorganic material.

When the charge generating layer including a first inorganic material includes the second inorganic material, an amount of the second inorganic material included in the charge generating layer may be selected in a range of about 0.1 by parts by weight to about 49.9 parts by weight, based on 50 parts by weight of the first inorganic material. For example, the amount of the second inorganic material included in the charge generating layer may be selected in a range of about 5 parts by weight to about 20 parts by weight, based on 50 parts by weight of the first inorganic material.

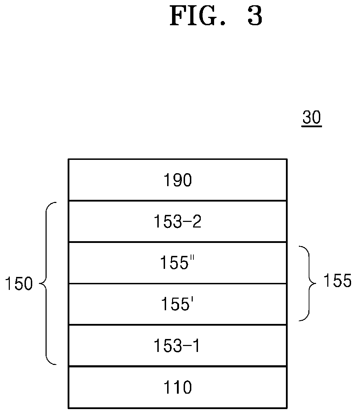

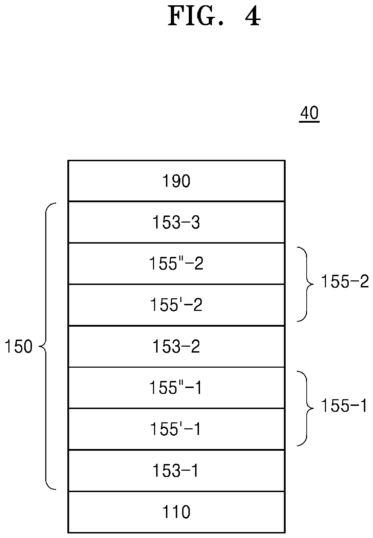

In the organic light-emitting device, m may be 2 or 3. An embodiment of an organic light-emitting device where m is 2 is the same as that described in connection with FIG. 3, and an embodiment of an organic light-emitting device where m is 3 is the same as that described in connection with FIG. 4.

In one or more embodiments, in the organic light-emitting device, m may be 2,
the m emission units include a first emission unit and a second emission unit,
the m-1 charge generating layers include a charge generating layer,
the charge generating layer is located between the first emission unit and the second emission unit,
the first emission unit is located between the first electrode and the charge generating layer,
the second emission unit is located between the charge generating layer and the second electrode,
the charge generating layer includes an n-type charge generating layer and a p-type charge generating layer, wherein the n-type charge generating layer is located between the first emission unit and the second emission unit, and the p-type charge generating layer is located between the n-type charge generating layer and the second emission unit, and
the p-type charge generating layer includes the first inorganic material.

Referring to FIG. 3, an organic light-emitting device 30 includes: a first electrode 110; a second electrode 190 facing the first electrode 110; a first emission unit 153-1 stacked between the first electrode 110 and the second electrode 190; a second emission unit 153-2 stacked between the first emission unit 153-1 and the second electrode 190; and a charge generating layer 155 between the first emission unit 153-1 and the second emission unit 153-2, wherein the first emission unit 153-1 is located between the first electrode 110 and the charge generating layer 155, the second emission unit 153-2 is located between the charge generating layer 155 and the second electrode 190, the charge generating layer 155 includes an n-type charge generating layer 155' and a p-type charge generating layer 155", the n-type charge generating layer 155' is located between the first emission unit 153-1 and the second emission unit 153-2, and the p-type charge generating layer 155" is located between the n-type charge generating layer 155' and the second emission unit 153-2.

In some embodiments, the organic light-emitting device 30 may further include the interlayer between the n-type charge generating layer 155' and the p-type charge generating layer 155".

In one or more embodiments, in the organic light-emitting device of the present embodiments, m may be 3,
the m emission units include a first emission unit, a second emission unit, and a third emission unit,
the m-1 charge generating layers include a first charge generating layer and a second charge generating layer,
the first charge generating layer is located between the first emission unit and the second emission unit,
the second charge generating layer is located between the second emission unit and the third emission unit,
the first emission unit is located between the first electrode and the first charge generating layer,
the second emission unit is located between the first charge generating layer and the second charge generating layer,
the third emission unit is located between the second charge generating layer and the second electrode,
the first charge generating layer includes a first n-type charge generating layer and a first p-type charge generating layer, wherein the first n-type charge generating layer is located between the first emission unit and the second emission unit, and the first p-type charge generating layer is located between the first n-type charge generating layer and the second emission unit,
the second charge generating layer include a second n-type charge generating layer and a second p-type charge generating layer, wherein the second n-type charge generating layer is located between the second emission unit and the third emission unit, and the second p-type charge generating layer may be located between the second n-type charge generating layer and the third emission unit, and
at least one of the first p-type charge generating layer and the second p-type charge generating layer includes the first inorganic material.

Referring to FIG. 4, an organic light-emitting device 40 includes: a first electrode 110; a second electrode 190 facing the first electrode 110; a first emission unit 153-1 stacked between the first electrode 110 and the second electrode 190; a second emission unit 153-2 stacked between the first emission unit 153-1 and the second electrode 190; a third emission unit 153-3 stacked between the second emission unit 153-2 and the second electrode 190; a first charge generating layer 155-1 between the first emission unit 153-1 and the second emission unit 153-2; and a second charge generating layer 155-2 between the second emission unit 153-2 and the third emission unit 153-3, wherein the first emission unit 153-1 is located between the first electrode 110 and the first charge generating layer 155-1, the second emission unit 153-2 is located between the first charge generating layer 155-1 and the second charge generating layer 155-2, the third emission unit 153-3 is located between the second charge generating layer 155-2 and the second electrode 190, the first charge generating layer 155-1 includes a first n-type charge generating layer 155'-1 and a first p-type charge generating layer 155"-1, the first n-type charge generating layer 155'-1 is located between the first emission unit 153-1 and the second emission unit 153-2, the first p-type charge generating layer 155"-1 is located between the first n-type charge generating layer 155'-1 and the second emission unit 153-2, the second charge generating layer 155-2 includes a second n-type charge generating layer 155'-2 and a second p-type charge generating layer 155"-2, the second n-type charge generating layer 155'-2 is located between the second emission unit 153-2 and the third emission unit 153-3, and the second p-type charge generating layer 155"-2 is located between the second n-type charge generating layer 155'-2 and the third emission unit 153-3.

In some embodiments, the organic light-emitting device 40 may further include the interlayer described above between the first n-type charge generating layer 155'-1 and the first p-type charge generating layer 155"-1 and/or between the second n-type charge generating layer 155'-2 and the second p-type charge generating layer 155"-2. For example, the interlayer may only be present between the first n-type charge generating layer 155'-1 and the first p-type charge generating layer 155"-1 or between the second n-type charge generating layer 155'-2 and the second p-type charge generating layer 155"-2, or may be present between the first n-type charge generating layer 155'-1 and the first p-type charge generating layer 155"-1, and between the first second n-type charge generating layer 155'-2 and the second p-type charge generating layer 155"-2.

In the related art, in a device in which two or more emission layers are sequentially stacked, a charge generating layer between the two or more emission layers may include an oxide or an organic material, wherein the oxide or the organic material has a deep lowest unoccupied molecular orbital (LUMO) energy level.

However, in the case of an oxide, a thermal evaporation temperature may be greater than 1,000 °C, which is extremely high, and in the case of an organic material, thermal evaporation may be achieved, but the price of the device may be extremely expensive.

Because in an organic light-emitting device according to the present disclosure, a charge generating layer, for example, a p-type charge generating layer, includes a first inorganic material capable of thermal deposition including a post transition metal and a metalloid, the resulting device may be characterized by low driving voltage and higher current density at the same voltage, while thermal evaporation may be achieved in a low temperature, and may have excellent characteristics in terms of color purity and efficiency that are greater than or equal to those of devices in the related art. Because the first inorganic material has a low thermal evaporation temperature compared to related metal materials, a thermal evaporation process may be achieved.

In addition, when the first inorganic material is a compound including a post transition metal and a metalloid, a work function of the first inorganic material may be adjusted by adjusting a ratio of the post transition metal and the metalloid. Thus, a barrier between an n-type charge generating layer and a p-type charge generating layer may be adjusted such that charge may be efficiently (or suitably) generated. For example, as a ratio of a metalloid increases, an absolute value of a work function of a first inorganic material increases, and for example, an amount of a metalloid may be greater than or equal to an amount of a post transition metal.

Table 1 shows work functions according to ratios of Bi and Te as compounds (post transition metal and metalloid, respectively) in the first inorganic material according to an embodiment.

**Table 1**

| Weight ratio (wt%) of Te relative to total compound | Composition ratio (Bi : Te) | Work function (eV) |
|---|---|---|
| 24% | 1 : 0.5 | -4.43 |
| 39 % | 1:1 | -4.55 |
| 47 % | 1 : 1.4 | -4.67 |
| 47.805 % | 1 : 1.5 | -4.91 |
| 50 % | 1 : 1.6 | -4.73 |
| 56 % | 1 : 2 | -4.71 |

As shown in Table 1, as a ratio of Te, which is a metalloid, increases, an absolute value of a work function generally (mostly) increases.

In addition, the organic light-emitting device may include the first inorganic material as a single-layered structure in a charge generating layer, or may include a hole transport material as well as the first inorganic material in a charge generating layer, and thus may include the first inorganic material as a dopant.

As described above, when an organic light-emitting device includes a hole transport material as well as the first inorganic material, electrical conductivity of a hole injection layer may increase, and thus charge may be efficiently (or suitably) generated, and hole transport to an adjacent emission unit may be further facilitated, resulting in improvement of efficiency of the device.

In addition, the organic light-emitting device may optionally further include an interlayer including the first inorganic material between an n-type charge generating layer and a p-type charge generating layer, and thus a barrier between the n-type charge generating layer and the p-type charge generating layer may be lowered, and N-P junction may be further facilitated, resulting in lowering driving voltage.

According to another embodiment, provided is a flat-display apparatus including: a thin-film transistor including a source electrode, a drain electrode, and an activation layer; and the organic light-emitting device, wherein the first electrode of the organic light-emitting device is electrically connected (coupled) with one selected from the source electrode and the drain electrode of the thin-film transistor.

The term "organic layer" as used herein refers to a single layer and/or a plurality of layers located between the first electrode and the second electrode of an organic light-emitting device. A material included in the "organic layer" is not limited to an organic material.

Hereinafter, structures of the organic light-emitting devices 10, 20, 30, and 40 according to embodiments and methods of manufacturing the same will be described in connection with FIGS. 1 to 4.

### First electrode 110

In FIGS. 1 to 4, a substrate may be additionally located under the first electrode 110 or above the second electrode 190. The substrate may be a glass substrate and/or a plastic substrate, each having excellent (or suitable) mechanical strength, thermal stability, transparency, surface smoothness, ease of handling, and/or water resistance.

The first electrode 110 may be formed by depositing or sputtering a material for forming the first electrode 110 on the substrate. When the first electrode 110 is an anode, the material for a first electrode may be selected from materials with a high work function to facilitate hole injection.

The first electrode 110 may be a reflective electrode, a semi-transmissive electrode, or a transmissive electrode. When the first electrode 110 is a transmissive electrode, a material for forming a first electrode 110 may be selected from indium tin oxide (ITO), indium zinc oxide (IZO), tin oxide (SnO₂), zinc oxide (ZnO), and any combination thereof, but embodiments of the present disclosure are not limited thereto. In one or more embodiments, when the first electrode 110 is a semi-transmissive electrode or a reflective electrode, a material for forming a first electrode may be selected from magnesium (Mg), silver (Ag), aluminium (Al), aluminium-lithium (Al-Li), calcium (Ca), magnesium-indium (Mg-In), magnesium-silver (Mg-Ag), and any combination thereof, but embodiments of the present disclosure are not limited thereto.

The first electrode 110 may have a single-layered structure or a multi-layered structure including two or more layers. For example, the first electrode 110 may have a three-layered structure of ITO/Ag/ITO, but the structure of the first electrode 110 is not limited thereto.

### Organic layer 150

The organic layer 150 is located on the first electrode 110. The organic layer 150 includes emission units 153, 153-1, 153-2, and 153-3.

The organic layer 150 may further include a hole transport region between the first electrode 110 and the emission units 153, 153-1, 153-2, and 153-3, and an electron transport region between the emission units 153, 153-1, 153-2, and 153-3 and the second electrode 190.

### Hole transport region in organic layer 150

The hole transport region may have i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure having a plurality of layers including (e.g., consisting of) a plurality of different materials.

The hole transport region may include at least one selected from a hole injection layer, a hole transport layer, an emission auxiliary layer, and an electron blocking layer.

For example, the hole transport region may have a single-layered structure including (e.g., consisting of) a single layer including (e.g., consisting of) a plurality of different materials, or a multi-layered structure having a hole injection layer/hole transport layer structure, a hole injection layer/hole transport layer/emission auxiliary layer structure, a hole injection layer/emission auxiliary layer structure, a hole transport layer/emission auxiliary layer structure, or a hole injection layer/hole transport layer/electron blocking layer structure, wherein for each structure, constituting layers are sequentially stacked from the first electrode 110 in this stated order, but the structure of the hole transport region is not limited thereto.

The hole transport region may include at least one selected from m-MTDATA, TDATA, 2-TNATA, NPB(NPD), β-NPB, TPD, spiro-TPD, spiro-NPB, methylated NPB, TAPC, HMTPD, 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201 below, and a compound represented by Formula 202 below:

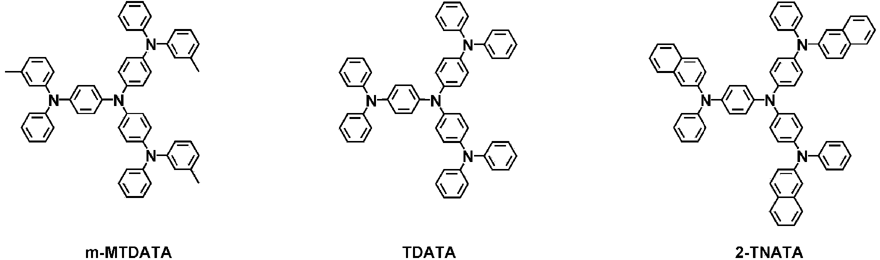

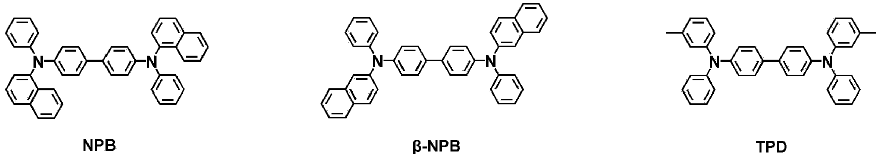

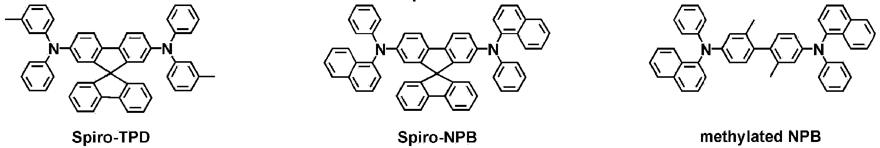

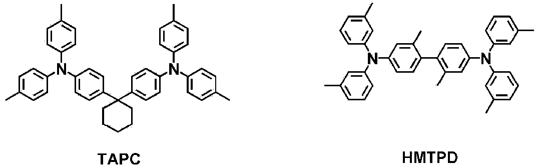

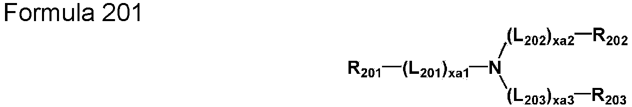

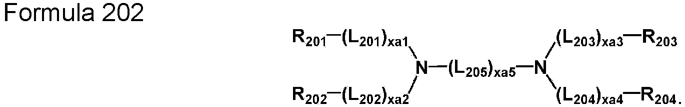

In Formulae 201 and 202,
L₂₀₁ to L₂₀₄ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₂) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
L₂₀₅ may be selected from *-O-*', *-S-*', *-N(Q₂₀₁)-*', a substituted or unsubstituted C₁-C₂₀ alkylene group, a substituted or unsubstituted C₂-C₂₀ alkenylene group, a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (*e*.*g*. C₆-C₃₂) arylene group, a substituted or unsubstituted C₁-C₆₀ (*e*.*g*. C₁-C₂₀) heteroarylene group, a substituted or unsubstituted divalent non-aromatic condensed polycyclic group, and a substituted or unsubstituted divalent non-aromatic condensed heteropolycyclic group,
xa1 to xa4 may each independently be an integer from 0 to 3,
xa5 may be an integer from 1 to 10, and
R₂₀₁ to R₂₀₄ and Q₂₀₁ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₂) aryl group, a substituted or unsubstituted C₆-C₆₀ (*e*.*g*. C₆-C₃₂) aryloxy group, a substituted or unsubstituted C₆-C₆₀ (*e*.*g*. C₆-C₃₂) arylthio group, a substituted or unsubstituted C₁-C₆₀ (*e*.*g*. C₁-C₂₀) heteroaryl group, a substituted or unsubstituted monovalent non-aromatic condensed polycyclic group, and a substituted or unsubstituted monovalent non-aromatic condensed heteropolycyclic group.

For example, in Formula 202, R₂₀₁ and R₂₀₂ may optionally be linked to each other via a single bond, a dimethyl-methylene group, and/or a diphenyl-methylene group, and R₂₀₃ and R₂₀₄ may optionally be linked to each other via a single bond, a dimethyl-methylene group, and/or a diphenyl-methylene group.

In one or more embodiments, in Formulae 201 and 202,

L₂₀₁ to L₂₀₅ may each independently be selected from:
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a pentalenylene group, an indenylene group, a naphthylene group, an azulenylene group, a heptalenylene group, an indacenylene group, an acenaphthylene group, a fluorenylene group, a spiro-bifluorenylene group, a benzofluorenylene group, a dibenzofluorenylene group, a phenalenylene group, a phenanthrenylene group, an anthracenylene group, a fluoranthenylene group, a triphenylenylene group, a pyrenylene group, a chrysenylene group, a naphthacenylene group, a picenylene group, a perylenylene group, a pentaphenylene group, a hexacenylene group, a pentacenylene group, a rubicenylene group, a coronenylene group, an ovalenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

In one or more embodiments, xa1 to xa4 may each independently be 0, 1, or 2.

In one or more embodiments, xa5 may be 1, 2, 3, or 4.

In one or more embodiments, R₂₀₁ to R₂₀₄ and Q₂₀₁ may each independently be selected from: a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, -Si(Q₃₁)(Q₃₂)(Q₃₃), and -N(Q₃₁)(Q₃₂),
wherein Q₃₁ to Q₃₃ are the same as described above.

In one or more embodiments, at least one selected from R₂₀₁ to R₂₀₃ in Formula 201 may each independently be selected from:
a fluorenyl group, a spiro-bifluorenyl group, a carbazolyl group, a dibenzofuranyl group, and a dibenzothiophenyl group; and
a fluorenyl group, a spiro-bifluorenyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, in Formula 202, i) R₂₀₁ and R₂₀₂ may be linked to each other via a single bond, and/or ii) R₂₀₃ and R₂₀₄ may be linked to each other via a single bond.

In one or more embodiments, at least one of R₂₀₁ to R₂₀₄ in Formula 202 may each independently be selected from:
a carbazolyl group; and
a carbazolyl group substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a naphthyl group, a fluorenyl group, a spiro-bifluorenyl group, a carbazolyl group, a dibenzofuranyl group, and a dibenzothiophenyl group,
but embodiments of the present disclosure are not limited thereto.

In one or more embodiments, the compound represented by Formula 201 may be represented by Formula 201A below:

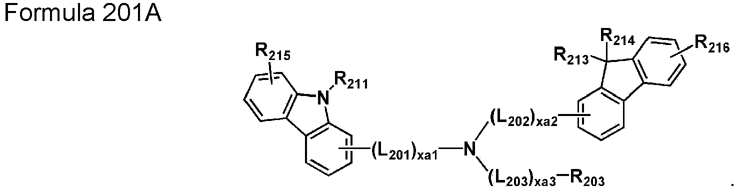

In one or more embodiments, the compound represented by Formula 201 may be represented by Formula 201A(1) below, but embodiments of the present disclosure are not limited thereto:

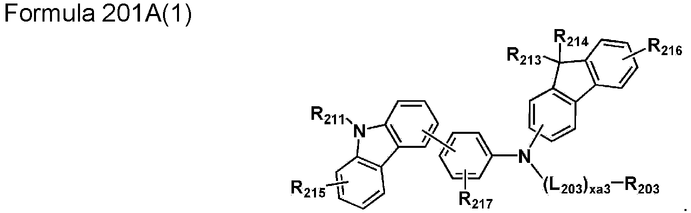

In one or more embodiments, the compound represented by Formula 201 may be represented by Formula 201A-1 below, but embodiments of the present disclosure are not limited thereto:

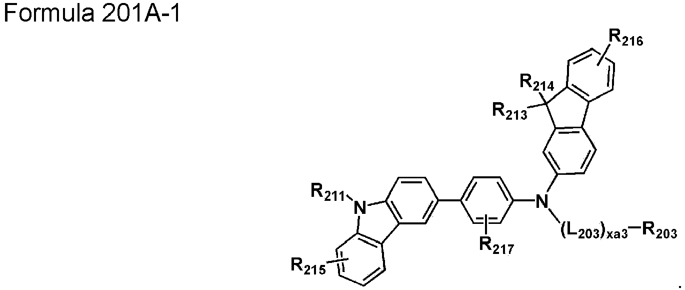

In one or more embodiments, the compound represented by Formula 202 may be represented by Formula 202A below:

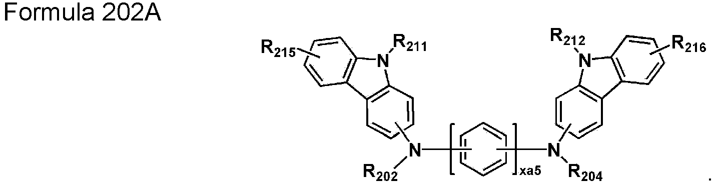

In one or more embodiments, the compound represented by Formula 202 may be represented by Formula 202A-1 below:

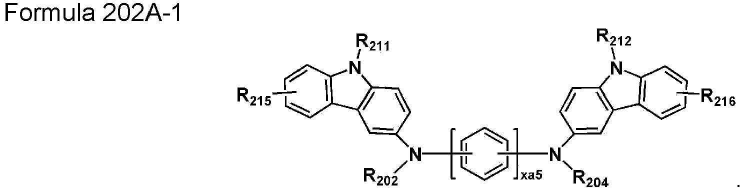

In Formulae 201A, 201A(1), 201A-1, 202A, and 202A-1,
L₂₀₁ to L₂₀₃, xa1 to xa3, xa5, and R₂₀₂ to R₂₀₄ are the same as described above,
R₂₁₁ and R₂₁₂ are each independently the same as described in connection with R₂₀₃, and
R₂₁₃ to R₂₁₇ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, a cycloheptyl group, a cyclopentenyl group, a cyclohexenyl group, a phenyl group, a biphenyl group, a terphenyl group, a phenyl group substituted with a C₁-C₁₀ alkyl group, a phenyl group substituted with -F, a pentalenyl group, an indenyl group, a naphthyl group, an azulenyl group, a heptalenyl group, an indacenyl group, an acenaphthyl group, a fluorenyl group, a spiro-bifluorenyl group, a benzofluorenyl group, a dibenzofluorenyl group, a phenalenyl group, a phenanthrenyl group, an anthracenyl group, a fluoranthenyl group, a triphenylenyl group, a pyrenyl group, a chrysenyl group, a naphthacenyl group, a picenyl group, a perylenyl group, a pentaphenyl group, a hexacenyl group, a pentacenyl group, a rubicenyl group, a coronenyl group, an ovalenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

The hole transport region may include at least one compound selected from Compounds HT1 to HT39, but compounds to be included in the hole transport region are not limited thereto:

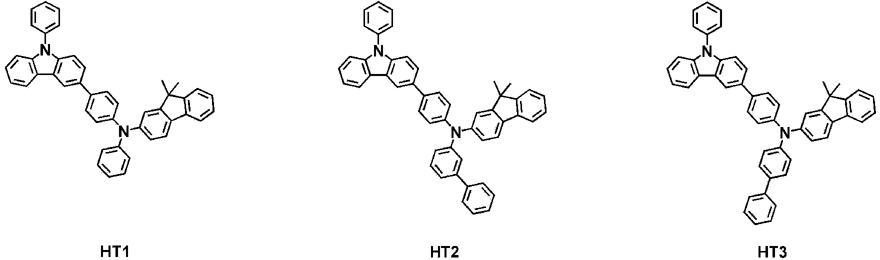

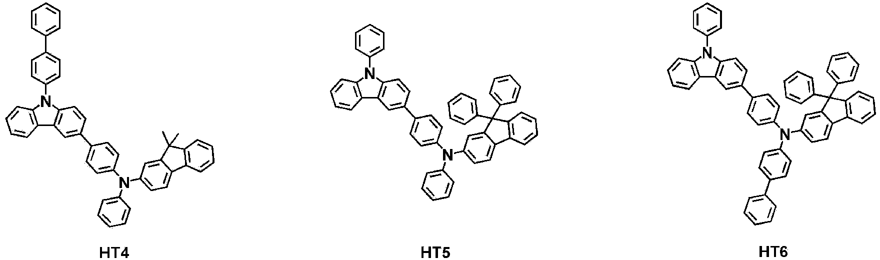

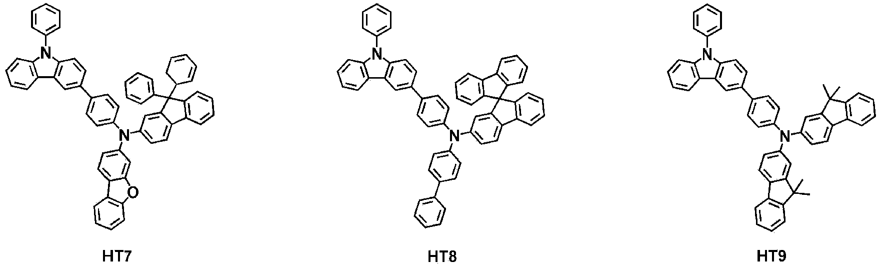

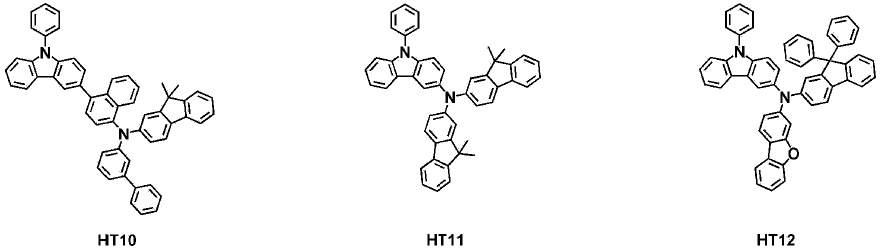

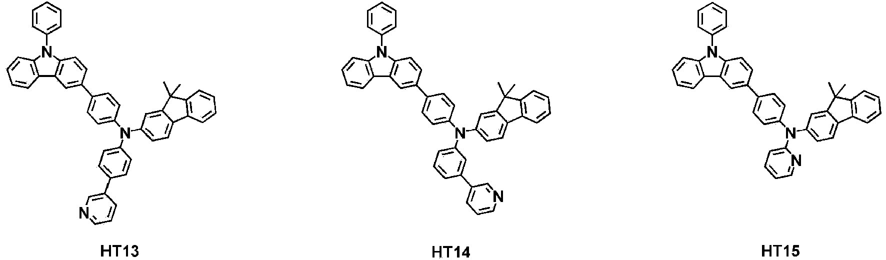

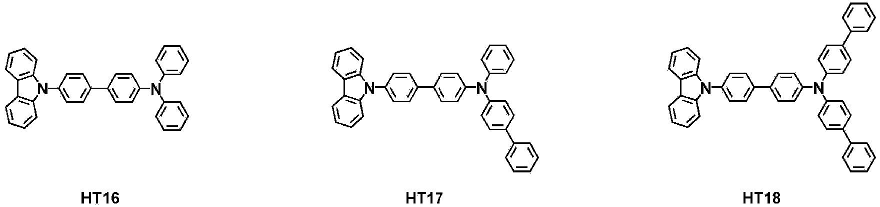

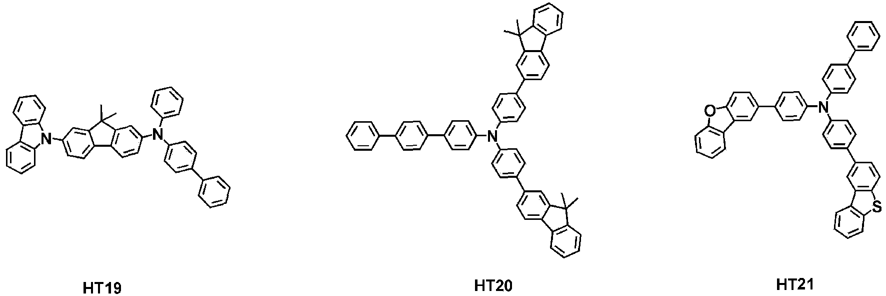

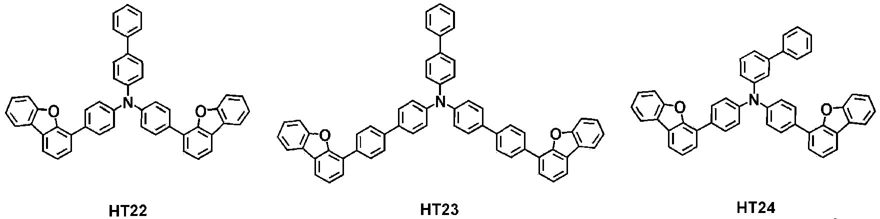

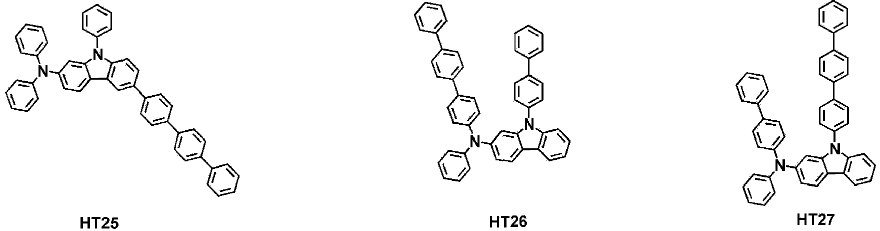

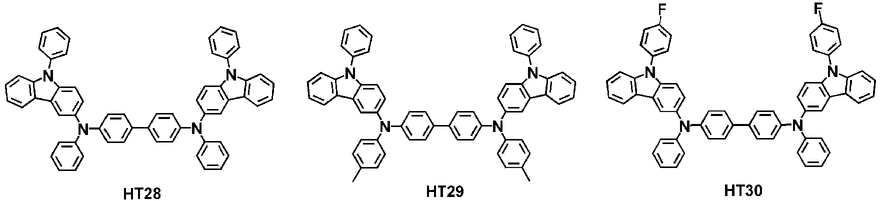

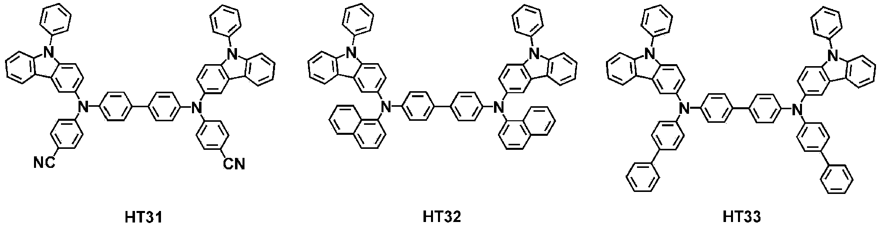

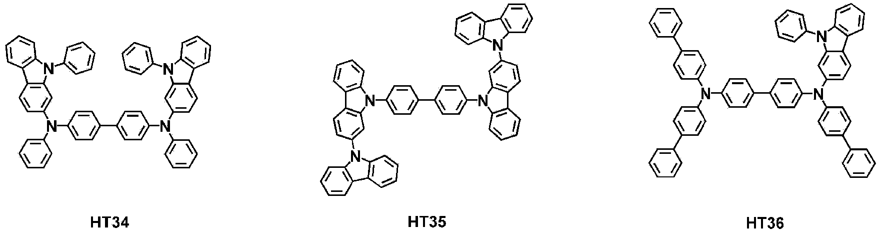

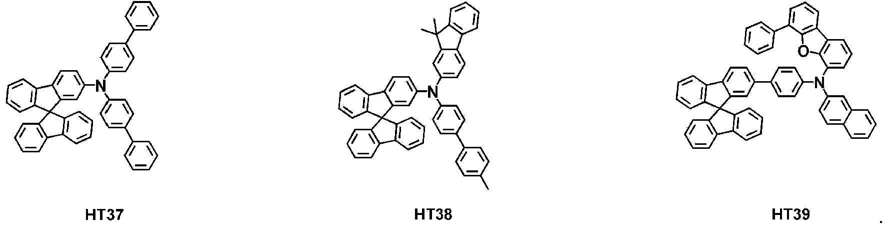

A thickness of the hole transport region may be in a range of about 50 Å to about 10,000 Å, for example, about 100 Å to about 1,000 Å. When the hole transport region includes at least one selected from a hole injection layer and a hole transport layer, the thickness of the hole injection layer may be in a range of about 100 Å to about 9,000 Å, for example, about 100 Å to about 1,000 Å, and the thickness of the hole transport layer may be in a range of about 50 Å to about 2,000 Å, for example, about 100 Å to about 1,500 Å. When the thicknesses of the hole transport region, the hole injection layer, and the hole transport layer are within any of these ranges, satisfactory (or suitable) hole transporting characteristics may be obtained without a substantial increase in driving voltage.

The emission auxiliary layer may increase light-emission efficiency by compensating for an optical resonance distance according to the wavelength of light emitted by an emission layer, and the electron blocking layer may block or reduce the flow of electrons from an electron transport region. The emission auxiliary layer and the electron blocking layer may each independently include any of the materials as described above.

### P-dopant

The hole transport region may further include, in addition to the materials described above, a charge-generation material for the improvement of conductive properties.

The charge-generation material may be homogeneously or non-homogeneously dispersed in the hole transport region.

The charge-generation material may be, for example, a p-dopant.

In one or more embodiments, a LUMO energy level of the p-dopant may be about -3.5 eV or less.

The p-dopant may include at least one selected from a quinone derivative, a metal oxide, and a cyano group-containing compound, but embodiments of the present disclosure are not limited thereto.

In one or more embodiments, the p-dopant may include at least one selected from:
a quinone derivative, such as tetracyanoquinodimethane (TCNQ) and/or 2,3,5,6-tetrafluoro-7,7,8,8-tetracyanoquinodimethane (F4-TCNQ);
a metal oxide, such as a tungsten oxide and/or a molybdenum oxide;
1,4,5,8,9,12-hexaazatriphenylene-hexacarbonitrile (HAT-CN); and
a compound represented by Formula 221 below,
but embodiments of the present disclosure are not limited thereto: 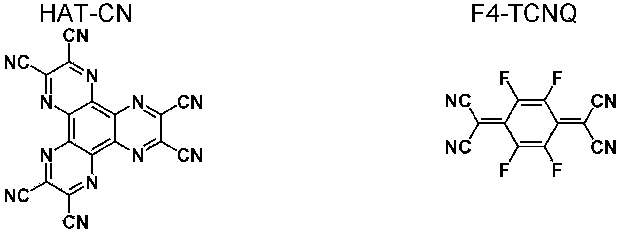 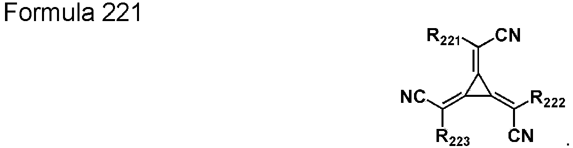
In Formula 221,
   R₂₂₁ to R₂₂₃ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₂) aryl group, a substituted or unsubstituted C₁-C₆₀ (*e*.*g*. C₁-C₂₀) heteroaryl group, a substituted or unsubstituted monovalent non-aromatic condensed polycyclic group, and a substituted or unsubstituted monovalent non-aromatic condensed heteropolycyclic group, and at least one of R₂₂₁ to R₂₂₃ may have at least one substituent selected from a cyano group, -F, -Cl, -Br, -I, a C₁-C₂₀ alkyl group substituted with -F, a C₁-C₂₀ alkyl group substituted with -Cl, a C₁-C₂₀ alkyl group substituted with -Br, and a C₁-C₂₀ alkyl group substituted with -I.

### Emission layer in organic layer 150

In the organic light-emitting devices 10, 20, 30, and 40, emission units 153, 153-1, 153-2, and 153-3 each include an emission layer, and the emission layer may have a stacked structure of two or more layers, in which the two or more layers selected from a red emission layer, green emission layer, a yellow emission layer, and a blue emission layer are in contact with each other or are separated apart from each other. In some embodiments, the emission layer may have a mixed structure of two or more materials, in which the two or more materials selected from a red light-emitting material, a green light-emitting material, a yellow light-emitting material, and a blue light-emitting material are mixed with each other in a single layer.

The emission layer may further include an electron transport (ET)-auxiliary layer formed on (e.g., on one side of) the emission layer and/or a hole transport (HT)-auxiliary layer formed under (e.g., on another side, opposite from the one side of) the emission layer. The HT-auxiliary layer is a layer that may act as the hole transport layer, the emission auxiliary layer, and/or the electron blocking layer, which are described above, and the ET-auxiliary layer is a layer that may act as a buffer layer, a hole blocking layer, an electron control layer, and/or an electron transport layer, which are described below. Materials that may be used in the HT-auxiliary layer and the ET-auxiliary layer are the same as described in connection with the hole transport region and an electron transport region described herein, respectively.

The emission layer may include a host and a dopant. The dopant may include at least one selected from a phosphorescent dopant and a fluorescent dopant.

An amount of a dopant in the emission layer may be, based on about 100 parts by weight of the host, in a range of about 0.01 parts by weight to about 15 parts by weight, but embodiments of the present disclosure are not limited thereto.

A thickness of the emission layer may be in a range of about 100 Å to about 1,000 Å, for example, about 200 Å to about 600 Å. When the thickness of the emission layer is within this range, excellent (or improved) light-emission characteristics may be obtained without a substantial increase in driving voltage.

### Host in emission layer

In one or more embodiments, the host may include a compound represented by Formula 301 below.

Formula 301 [Ar₃₀₁]_{xb11}-[(L₃₀₁)_{xb1}-R₃₀₁]_{xb21}.

In Formula 301,
Ar₃₀₁ may be a substituted or unsubstituted C₅-C₆₀ carbocyclic group or a substituted or unsubstituted C₁-C₆₀ heterocyclic group,
xb11 may be 1, 2, or 3,
L₃₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xb1 may be an integer from 0 to 5,
R₃₀₁ may be selected from deuterium, -F, -Cl, -Br, -I, a hydroxyl group, a cyano group, a nitro group, an amidino group, a hydrazino group, a hydrazono group, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₃₀₁)(Q₃₀₂)(Q₃₀₃), -N(Q₃₀₁)(Q₃₀₂), -B(Q₃₀₁)(Q₃₀₂), -C(=O)(Q₃₀₁), -S(=O)₂(Q₃₀₁), and - P(=O)(Q₃₀₁)(Q₃₀₂), and
xb21 may be an integer from 1 to 5,
wherein Q₃₀₁ to Q₃₀₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

For example, Ar₃₀₁ may be a substituted or unsubstituted C₆-C₃₂ carbocyclic group or a substituted or unsubstituted C₁-C₁₂ heterocyclic group, but embodiments are not limited thereto.

In one or more embodiments, Ar₃₀₁ in Formula 301 may be selected from:
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group; and
a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, and a dibenzothiophene group, each substituted with at least one selected from deuterium, - F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, - Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and - P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group, but embodiments of the present disclosure are not limited thereto.

When xb11 in Formula 301 is 2 or more, two or more of Ar₃₀₁(s) may be linked via a single bond.

In one or more embodiments, the compound represented by Formula 301 may be represented by one of Formula 301-1 or Formula 301-2:

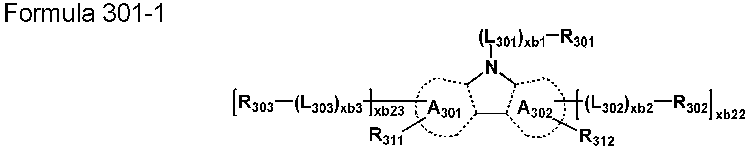

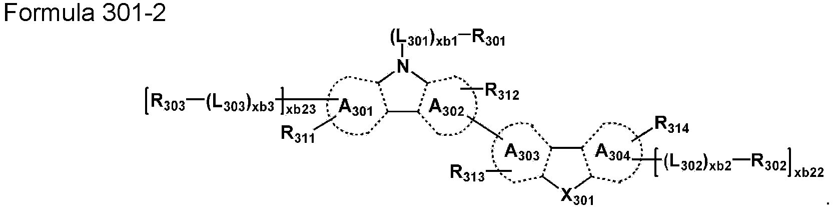

In Formulae 301-1 and 301-2,
A₃₀₁ to A₃₀₄ may each independently be selected from a benzene, a naphthalene, a phenanthrene, a fluoranthene, a triphenylene, a pyrene, a chrysene, a pyridine, a pyrimidine, an indene, a fluorene, a spiro-bifluorene, a benzofluorene, a dibenzofluorene, an indole, a carbazole, a benzocarbazole, a dibenzocarbazole, a furan, a benzofuran, a dibenzofuran, a naphthofuran, a benzonaphthofuran, a dinaphthofuran, a thiophene, a benzothiophene, a dibenzothiophene, a naphthothiophene, a benzonaphthothiophene, and a dinaphthothiophene,
X₃₀₁ may be O, S, or N-[(L₃₀₄)_{xb4}-R₃₀₄],
R₃₁₁ to R₃₁₄ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group -Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
xb22 and xb23 may each independently be 0, 1, or 2,
L₃₀₁, xb1, R₃₀₁, and Q₃₁ to Q₃₃ are the same as described above,
L₃₀₂ to L₃₀₄ are each independently the same as described in connection with L₃₀₁,
xb2 to xb4 are each independently the same as described in connection with xb1, and
R₃₀₂ to R₃₀₄ may each independently be the same as described in connection with R₃₀₁.

For example, L₃₀₁ to L₃₀₄ in Formulae 301, 301-1, and 301-2 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂);
wherein Q₃₁ to Q₃₃ are the same as described above.

As another example, R₃₀₁ to R₃₀₄ in Formulae 301, 301-1, and 301-2 may each independently be selected from: deuterium, -F, -Cl, -Br, -I, a hydroxyl group, a cyano group, a nitro group, an amidino group, a hydrazino group, a hydrazono group, a substituted or unsubstituted C₁-C₆₀ (*e*.*g*. C₁-C₁₀) alkyl group, a substituted or unsubstituted C₂-C₆₀ (*e*.*g*. C₂-C₁₀) alkenyl group, a substituted or unsubstituted C₂-C₆₀ (*e*.*g*. C₂-C₁₀) alkynyl group, a substituted or unsubstituted C₁-C₆₀ (*e*.*g*. C₁-C₁₀) alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, -Si(Q₃₀₁)(Q₃₀₂)(Q₃₀₃), -N(Q₃₀₁)(Q₃₀₂), - B(Q₃₀₁)(Q₃₀₂), -C(=O)(Q₃₀₁), -S(=O)₂(Q₃₀₁), and -P(=O)(Q₃₀₁)(Q₃₀₂), but embodiments are not limited thereto.

In one or more embodiments, R₃₀₁ to R₃₀₄ in Formulae 301, 301-1, and 301-2 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, an azacarbazolyl group, -Si(Q₃₁)(Q₃₂)(Q₃₃), -N(Q₃₁)(Q₃₂), - B(Q₃₁)(Q₃₂), -C(=O)(Q₃₁), -S(=O)₂(Q₃₁), and -P(=O)(Q₃₁)(Q₃₂), and
wherein Q₃₁ to Q₃₃ are the same as described above.

In one or more embodiments, the host may include an alkaline earth-metal complex. For example, the host may include a complex selected from a Be complex (for example, Compound H55), a Mg complex, and a Zn complex. For example, the host may be selected from a Be complex (for example, Compound H55), an Mg complex, and/or a Zn complex.

The host may include at least one selected from 9,10-di(2-naphthyl)anthracene (ADN), 2-methyl-9,10-bis(naphthalen-2-yl)anthracene (MADN), 9,10-di-(2-naphthyl)-2-t-butyl-anthracene (TBADN), 4,4'-bis(N-carbazolyl)-1,1'-biphenyl (CBP), 1,3-di-9-carbazolylbenzene (mCP), 1,3,5-tri(carbazol-9-yl)benzene (TCP), and Compounds H1 to H55, but embodiments of the present disclosure are not limited thereto:

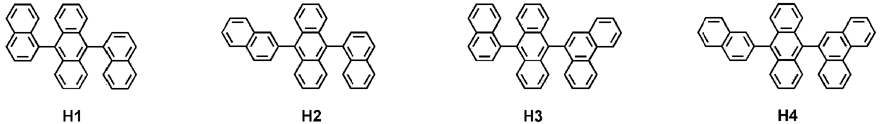

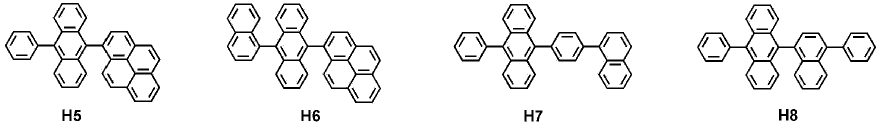

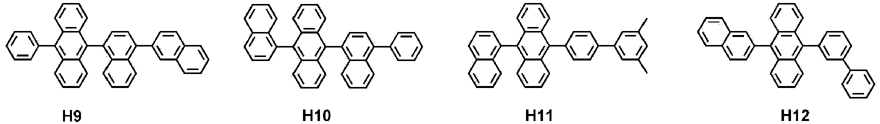

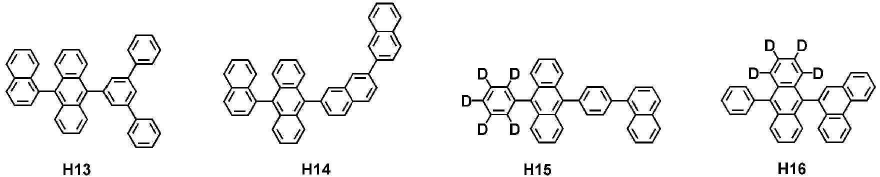

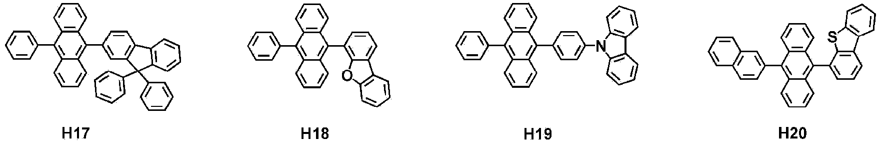

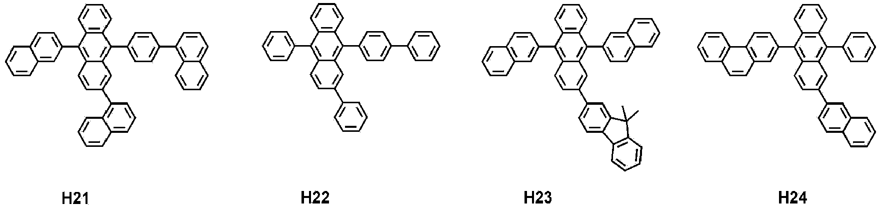

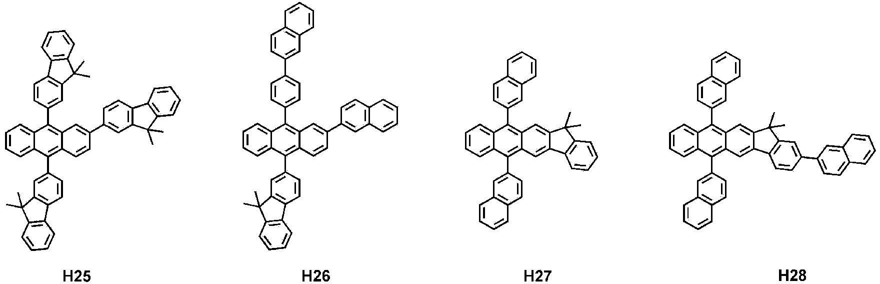

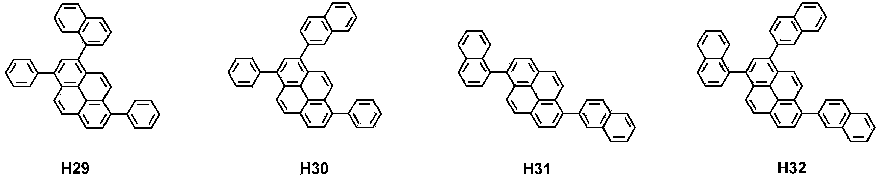

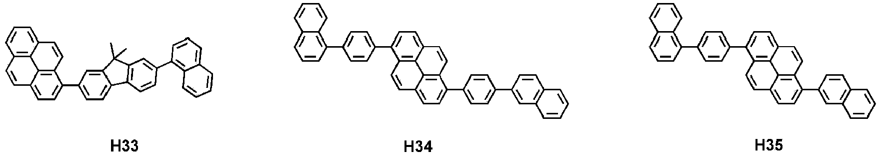

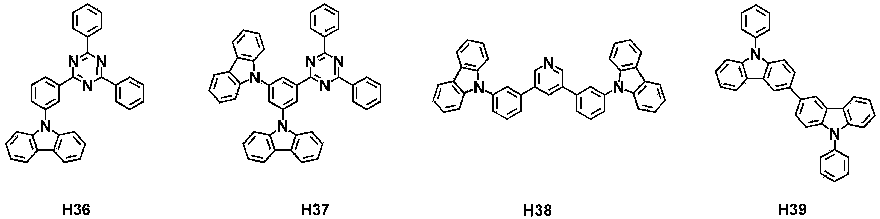

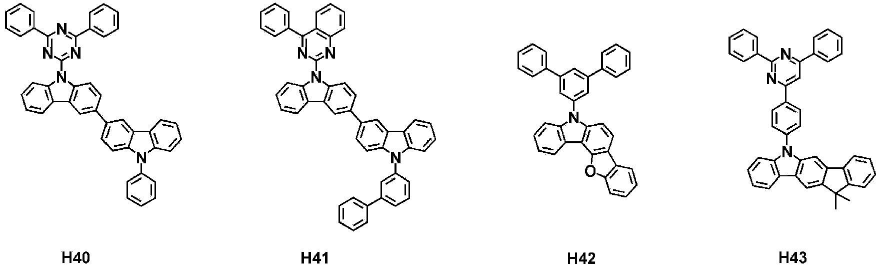

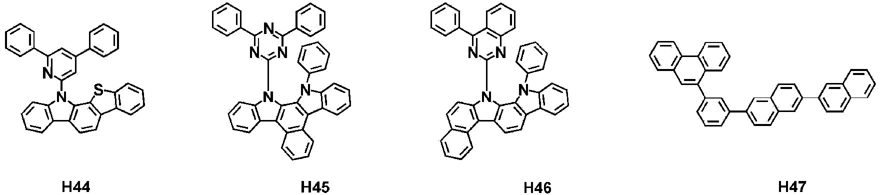

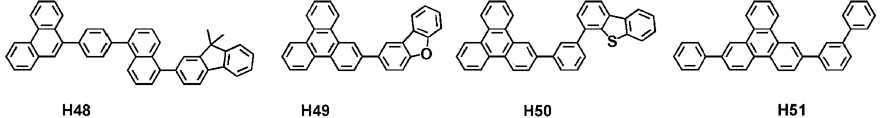

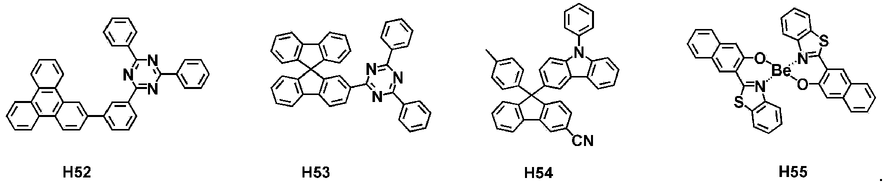

### Phosphorescent dopant included in emission layer in organic layer 150

The phosphorescent dopant may include an organometallic complex represented by Formula 401 below:

Formula 401 M(L₄₀₁)_{xc1}(L₄₀₂)_{xc2}

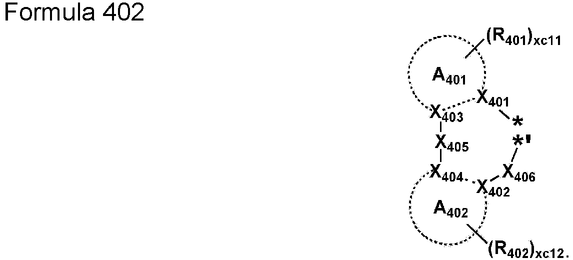

In Formulae 401 and 402,
M may be selected from iridium (Ir), platinum (Pt), palladium (Pd), osmium (Os), titanium (Ti), zirconium (Zr), hafnium (Hf), europium (Eu), terbium (Tb), rhodium (Rh), and thulium (Tm),
L₄₀₁ may be a ligand represented by Formula 402, and xc1 may be 1, 2, or 3, wherein, when xc1 is 2 or more, two or more of L₄₀₁(s) may be identical to or different from each other,
L₄₀₂ may be an organic ligand, and xc2 may be an integer from 0 to 4, wherein, when xc2 is 2 or more, two or more of L₄₀₂(s) may be identical to or different from each other,
X₄₀₁ to X₄₀₄ may each independently be nitrogen or carbon,
X₄₀₁ and X₄₀₃ may be linked via a single bond or a double bond, and X₄₀₂ and X₄₀₄ may be linked via a single bond or a double bond,
A₄₀₁ and A₄₀₂ may each independently be a C₅-C₆₀ (*e*.*g*. C₅-C₃₀) carbocyclic group or a C₁-C₆₀ (*e*.*g*. C₁-C₂₀) heterocyclic group,
X₄₀₅ may be a single bond, *-O-*', *-S-*', *-C(=O)-*', *-N(Q₄₁₁)-*', *-C(Q₄₁₁)(Q₄₁₂)-*', *-C(Q₄₁₁)=C(Q₄₁₂)-*', *-C(Q₄₁₁)=*', or *=C=*', wherein Q₄₁₁ and Q₄₁₂ may be hydrogen, deuterium, a C₁-C₂₀ alkyl group, a C₁-C₂₀ alkoxy group, a phenyl group, a biphenyl group, a terphenyl group, or a naphthyl group,
X₄₀₆ may be a single bond, O, or S,
R₄₀₁ and R₄₀₂ may each independently be selected from hydrogen, deuterium, -F, -Cl, -Br, -I, a hydroxyl group, a cyano group, a nitro group, an amidino group, a hydrazino group, a hydrazono group, a substituted or unsubstituted C₁-C₂₀ alkyl group, a substituted or unsubstituted C₁-C₂₀ alkoxy group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (*e*.*g*. C₆-C₃₀) aryl group, a substituted or unsubstituted C₆-C₆₀ (*e*.*g*. C₆-C₃₀) aryloxy group, a substituted or unsubstituted C₆-C₆₀ (*e*.*g*. C₆-C₃₀) arylthio group, a substituted or unsubstituted C₁-C₆₀ (*e.g*. C₁-C₂₀) heteroaryl group, a substituted or unsubstituted monovalent non-aromatic condensed polycyclic group, and a substituted or unsubstituted monovalent non-aromatic condensed heteropolycyclic group, -Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), -S(=O)₂(Q₄₀₁), and -P(=O)(Q₄₀₁)(Q₄₀₂), wherein Q₄₀₁ to Q₄₀₃ may each independently be selected from a C₁-C₁₀ alkyl group, a C₁-C₁₀ alkoxy group, a C₆-C₂₀ aryl group, and a C₁-C₂₀ heteroaryl group,
xc11 and xc12 may each independently be an integer from 0 to 10, and
* and *' in Formula 402 each indicate a binding site to M in Formula 401.

In one or more embodiments, A₄₀₁ and A₄₀₂ in Formula 402 may each independently be selected from a benzene group, a naphthalene group, a fluorene group, a spiro-bifluorene group, an indene group, a pyrrole group, a thiophene group, a furan group, an imidazole group, a pyrazole group, a thiazole group, an isothiazole group, an oxazole group, an isoxazole group, a pyridine group, a pyrazine group, a pyrimidine group, a pyridazine group, a quinoline group, an isoquinoline group, a benzoquinoline group, a quinoxaline group, a quinazoline group, a carbazole group, a benzimidazole group, a benzofuran group, a benzothiophene group, an isobenzothiophene group, a benzoxazole group, an isobenzoxazole group, a triazole group, a tetrazole group, an oxadiazole group, a triazine group, a dibenzofuran group, and a dibenzothiophene group.

In one or more embodiments, in Formula 402, i) X₄₀₁ may be nitrogen, and X₄₀₂ may be carbon, or ii) each of X₄₀₁ and X₄₀₂ may be nitrogen.

In one or more embodiments, R₄₀₁ and R₄₀₂ in Formula 402 may each independently be selected from:
hydrogen, deuterium, -F, -Cl, -Br, -I, a hydroxyl group, a cyano group, a nitro group, an amidino group, a hydrazino group, a hydrazono group, a C₁-C₂₀ alkyl group, and a C₁-C₂₀ alkoxy group;
a C₁-C₂₀ alkyl group and a C₁-C₂₀ alkoxy group, each substituted with at least one selected from deuterium, -F, -Cl, -Br, -I, a hydroxyl group, a cyano group, a nitro group, an amidino group, a hydrazino group, a hydrazono group, a phenyl group, a naphthyl group, a cyclopentyl group, a cyclohexyl group, an adamantanyl group, a norbornanyl group, and a norbornenyl group;
a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group;
a cyclopentyl group, a cyclohexyl group, an adamantanyl group, a norbornanyl group, a norbornenyl group a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a cyclopentyl group, a cyclohexyl group, an adamantanyl group, a norbornanyl group, a norbornenyl group, a phenyl group, a biphenyl group, a terphenyl group, a naphthyl group, a fluorenyl group, a pyridinyl group, a pyrazinyl group, a pyrimidinyl group, a pyridazinyl group, a triazinyl group, a quinolinyl group, an isoquinolinyl group, a quinoxalinyl group, a quinazolinyl group, a carbazolyl group, a dibenzofuranyl group, and a dibenzothiophenyl group; and
-Si(Q₄₀₁)(Q₄₀₂)(Q₄₀₃), -N(Q₄₀₁)(Q₄₀₂), -B(Q₄₀₁)(Q₄₀₂), -C(=O)(Q₄₀₁), - S(=O)₂(Q₄₀₁), and -P(=O)(Q₄₀₁)(Q₄₀₂),
wherein Q₄₀₁ to Q₄₀₃ may each independently be selected from a C₁-C₁₀ alkyl group, a C₁-C₁₀ alkoxy group, a phenyl group, a biphenyl group, and a naphthyl group, but embodiments of the present disclosure are not limited thereto.

In one or more embodiments, when xc1 in Formula 401 is 2 or more, two A₄₀₁(s) in two or more of L₄₀₁(s) may optionally be linked to each other via X₄₀₇, which is a linking group, or two A₄₀₂(s) may optionally be linked to each other via X₄₀₈, which is a linking group (see e.g., Compounds PD1 to PD4 and PD7). X₄₀₇ and X₄₀₈ may each independently be a single bond, *-O-*', *-S-*', *-C(=O)-*', *-N(Q₄₁₃)-*', *-C(Q₄₁₃)(Q₄₁₄)-*', or *-C(Q₄₁₃)=C(Q₄₁₄)-*' (wherein Q₄₁₃ and Q₄₁₄ may each independently be hydrogen, deuterium, a C₁-C₂₀ alkyl group, a C₁-C₂₀ alkoxy group, a phenyl group, a biphenyl group, a terphenyl group, or a naphthyl group), but embodiments of the present disclosure are not limited thereto.

L₄₀₂ in Formula 401 may be a monovalent, divalent, or trivalent organic ligand. For example, L₄₀₂ may be selected from halogen, diketone (for example, acetylacetonate), carboxylic acid (for example, picolinate), -C(=O), isonitrile, -CN, and phosphorus (for example, phosphine and/or phosphite), but embodiments of the present disclosure are not limited thereto.

In one or more embodiments, the phosphorescent dopant may be selected from, for example, Compounds PD1 to PD25, but embodiments of the present disclosure are not limited thereto:

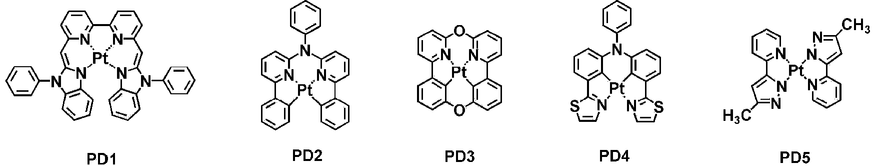

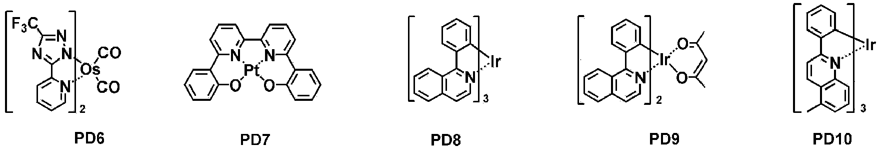

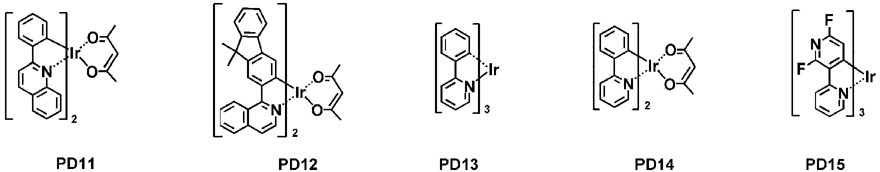

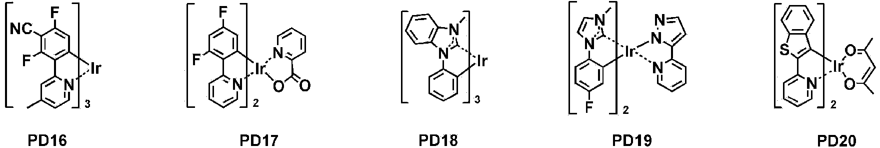

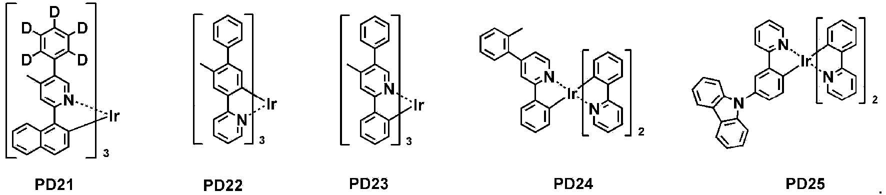

### Fluorescent dopant in emission layer

The fluorescent dopant may include an arylamine compound or a styrylamine compound.

The fluorescent dopant may include a compound represented by Formula 501 below.

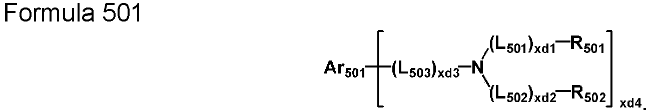

In Formula 501,
Ar₅₀₁ may be a substituted or unsubstituted C₅-C₆₀ carbocyclic group or a substituted or unsubstituted C₁-C₆₀ heterocyclic group,
L₅₀₁ to L₅₀₃ may each independently be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ (e.g. C₆-C₃₀) arylene group, a substituted or unsubstituted C₁-C₆₀ (e.g. C₁-C₂₀) heteroarylene group, a substituted or unsubstituted divalent non-aromatic condensed polycyclic group, and a substituted or unsubstituted divalent non-aromatic condensed heteropolycyclic group,
xd1 to xd3 may each independently be an integer from 0 to 3,
R₅₀₁ and R₅₀₂ may each independently be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ (e.g. C₆-C₃₀) aryl group, a substituted or unsubstituted C₆-C₆₀ (e.g. C₆-C₃₀) aryloxy group, a substituted or unsubstituted C₆-C₆₀ (e.g. C₆-C₃₀) arylthio group, a substituted or unsubstituted C₁-C₆₀ (e.g. C₁-C₂₀) heteroaryl group, a substituted or unsubstituted monovalent non-aromatic condensed polycyclic group, and a substituted or unsubstituted monovalent non-aromatic condensed heteropolycyclic group, and
xd4 may be an integer from 1 to 6.

For example, Ar₅₀₁ may be a substituted or unsubstituted C₅-C₃₀ carbocyclic group or a substituted or unsubstituted C₁-C₂₀ heterocyclic group, but embodiments are not limited thereto.

In one or more embodiments, Ar₅₀₁ in Formula 501 may be selected from:
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group; and
a naphthalene group, a heptalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, and an indenophenanthrene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

In one or more embodiments, L₅₀₁ to L₅₀₃ in Formula 501 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, and a pyridinylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group.

In one or more embodiments, R₅₀₁ and R₅₀₂ in Formula 501 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group; and
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, and a pyridinyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, and - Si(Q₃₁)(Q₃₂)(Q₃₃),
wherein Q₃₁ to Q₃₃ may be selected from a C₁-C₁₀ alkyl group, a C₁-C₁₀ alkoxy group, a phenyl group, a biphenyl group, a terphenyl group, and a naphthyl group.

In one or more embodiments, xd4 in Formula 501 may be 2, but embodiments of the present disclosure are not limited thereto.

For example, the fluorescent dopant may be selected from Compounds FD1 to FD22:

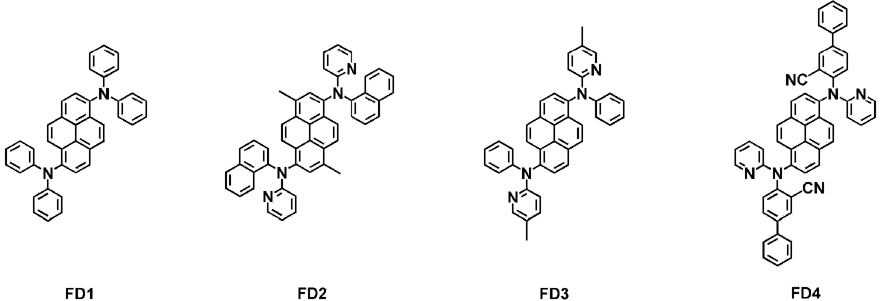

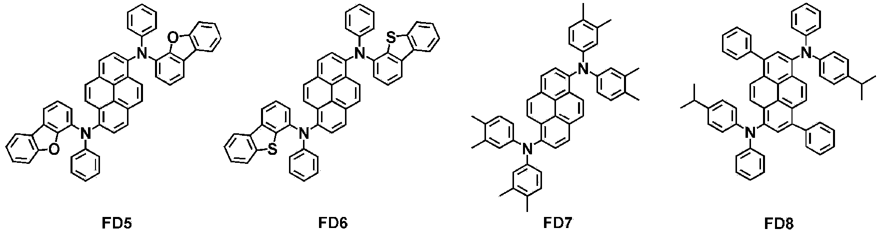

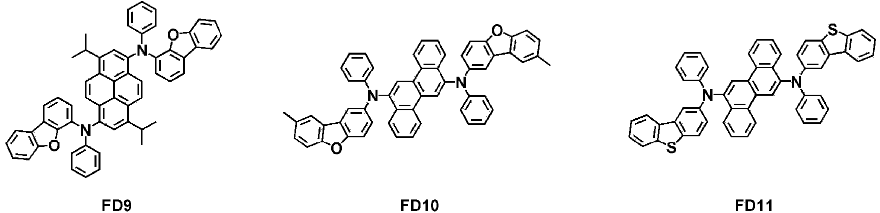

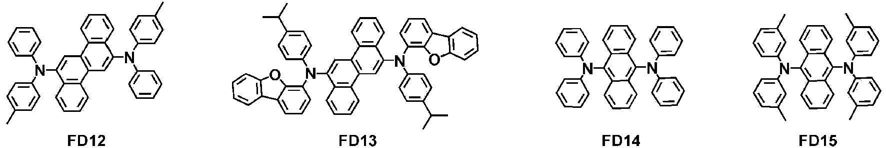

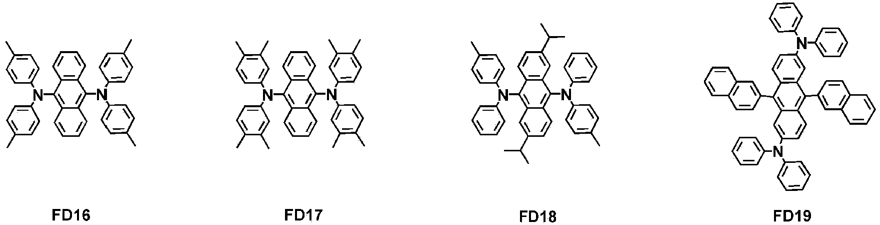

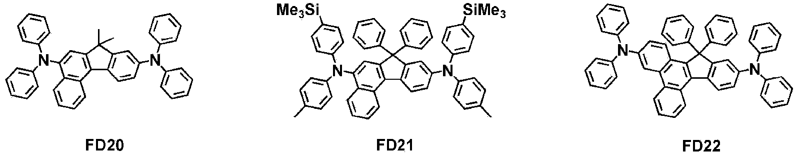

In one or more embodiments, the fluorescent dopant may be selected from the following compounds, but embodiments of the present disclosure are not limited thereto.

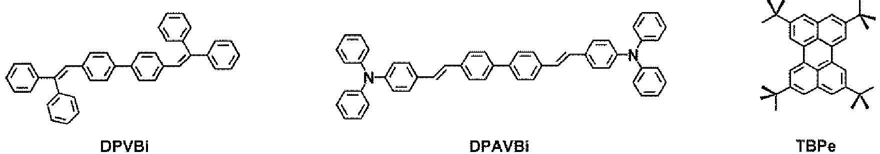

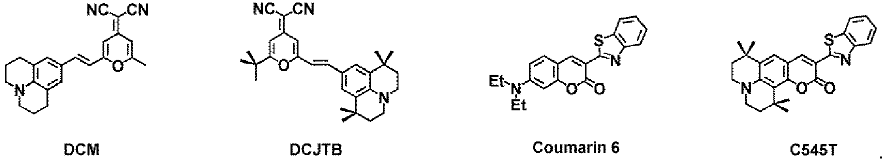

### Electron transport region in organic layer 150

The electron transport region may have i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure having a plurality of layers including (e.g., consisting of) a plurality of different materials.

The electron transport region may include at least one selected from a buffer layer, a hole blocking layer, an electron control layer, an electron transport layer, and an electron injection layer, but embodiments of the present disclosure are not limited thereto.

For example, the electron transport region may have an electron transport layer/electron injection layer structure, a hole blocking layer/electron transport layer/electron injection layer structure, an electron control layer/electron transport layer/electron injection layer structure, or a buffer layer/electron transport layer/electron injection layer structure, wherein for each structure, constituting layers are sequentially stacked from an emission layer. However, embodiments of the structure of the electron transport region are not limited thereto.

The electron transport region (for example, a buffer layer, a hole blocking layer, an electron control layer, and/or an electron transport layer in the electron transport region) may include a metal-free compound containing at least one π electron-deficient nitrogen-containing ring.

The "π electron-deficient nitrogen-containing ring" indicates a C₁-C₆₀ (e.g. a C₁-C₃₀) heterocyclic group having at least one *-N=*' moiety as a ring-forming moiety.

For example, the "π electron-depleted nitrogen-containing ring" may be i) a 5-membered to 7-membered heteromonocyclic group having at least one *-N=*' moiety, ii) a heteropolycyclic group in which two or more 5-membered to 7-membered heteromonocyclic groups, each having at least one *-N=*' moiety, are condensed with each other, or iii) a heteropolycyclic group in which at least one of 5-membered to 7-membered heteromonocyclic groups, each having at least one *-N=*' moiety, is condensed with at least one C₅-C₆₀ (*e.g*. a C₅-C₃₀) carbocyclic group.

Examples of the π electron-deficient nitrogen-containing ring include an imidazole ring, a pyrazole ring, a thiazole ring, an isothiazole ring, an oxazole ring, an isoxazole ring, a pyridine ring, a pyrazine ring, a pyrimidine ring, a pyridazine ring, an indazole ring, a purine ring, a quinoline ring, an isoquinoline ring, a benzoquinoline ring, a phthalazine ring, a naphthyridine ring, a quinoxaline ring, a quinazoline ring, a cinnoline ring, a phenanthridine ring, an acridine ring, a phenanthroline ring, a phenazine ring, a benzimidazole ring, an isobenzothiazole ring, a benzoxazole ring, an isobenzoxazole ring, a triazole ring, a tetrazole ring, an oxadiazole ring, a triazine ring, a thiadiazole ring, an imidazopyridine ring, an imidazopyrimidine ring, and an azacarbazole ring, but are not limited thereto.

For example, the electron transport region may include a compound represented by Formula 601 below:

Formula 601 [Ar₆₀₁]ₓₑ₁₁-[(L₆₀₁)ₓₑ₁-R₆₀₁]ₓₑ₂₁.

In Formula 601,
Ar₆₀₁ may be a substituted or unsubstituted C₅-C₆₀ carbocyclic group or a substituted or unsubstituted C₁-C₆₀ heterocyclic group,
xe11 may be 1, 2, or 3,
L₆₀₁ may be selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 may be an integer from 0 to 5,
R₆₀₁ may be selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
Q₆₀₁ to Q₆₀₃ may each independently be a C₁-C₁₀ alkyl group, a C₁-C₁₀ alkoxy group, a phenyl group, a biphenyl group, a terphenyl group, or a naphthyl group, and
xe21 may be an integer from 1 to 5.

In one or more embodiments, at least one of Ar₆₀₁(s) in the number of xe11 and R₆₀₁(s) in the number of xe21 may include the π electron-deficient nitrogen-containing ring.

For example, Ar₆₀₁ may be a substituted or unsubstituted C₅-C₃₀ carbocyclic group or a substituted or unsubstituted C₁-C₂₀ heterocyclic group, but embodiments are not limited thereto.

In one or more embodiments, ring Ar₆₀₁ in Formula 601 may be selected from:
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group; and
a benzene group, a naphthalene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, an indenoanthracene group, a dibenzofuran group, a dibenzothiophene group, a carbazole group, an imidazole group, a pyrazole group, a thiazole group, an isothiazole group, an oxazole group, an isoxazole group, a pyridine group, a pyrazine group, a pyrimidine group, a pyridazine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, and an azacarbazole group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, -Si(Q₃₁)(Q₃₂)(Q₃₃), -S(=O)₂(Q₃₁), and -P(=O)(Q₃₁)(Q₃₂),
wherein Q₃₁ to Q₃₃ may each independently be selected from a C₁-C₁₀ alkyl group, a C₁-C₁₀ alkoxy group, a phenyl group, a biphenyl group, a terphenyl group, and a naphthyl group.

When xe11 in Formula 601 is 2 or more, two or more of Ar₆₀₁(s) may be linked to each other via a single bond.

In one or more embodiments, Ar₆₀₁ in Formula 601 may be an anthracene group.

In one or more embodiments, the compound represented by Formula 601 may be represented by Formula 601-1:

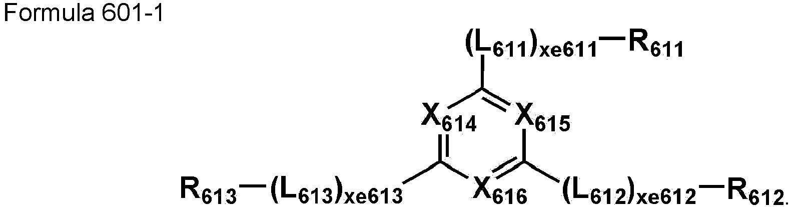

In Formula 601-1,
X₆₁₄ may be N or C(R₆₁₄), X₆₁₅ may be N or C(R₆₁₅), X₆₁₆ may be N or C(R₆₁₆), and at least one of X₆₁₄ to X₆₁₆ may be N,
L₆₁₁ to L₆₁₃ may each independently be the same as described in connection with L₆₀₁,
xe611 to xe613 may each independently be the same as described in connection with xe1,
R₆₁₁ to R₆₁₃ may each independently be the same as described in connection with R₆₀₁, and
R₆₁₄ to R₆₁₆ may each independently be selected from hydrogen, deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, and a naphthyl group.

For example, L₆₀₁ and L₆₁₁ to L₆₁₃ in Formulae 601 and 601-1 may each independently be selected from: a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₃₀ arylene group, a substituted or unsubstituted C₁-C₂₀ heteroarylene group, a substituted or unsubstituted divalent non-aromatic condensed polycyclic group, and a substituted or unsubstituted divalent non-aromatic condensed heteropolycyclic group, but embodiments are not limited thereto.

In one or more embodiments, L₆₀₁ and L₆₁₁ to L₆₁₃ in Formulae 601 and 601-1 may each independently be selected from:
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group; and
a phenylene group, a naphthylene group, a fluorenylene group, a spiro-bifluorenylene group, a benzofluorenylene group, a dibenzofluorenylene group, a phenanthrenylene group, an anthracenylene group, a fluoranthenylene group, a triphenylenylene group, a pyrenylene group, a chrysenylene group, a perylenylene group, a pentaphenylene group, a hexacenylene group, a pentacenylene group, a thiophenylene group, a furanylene group, a carbazolylene group, an indolylene group, an isoindolylene group, a benzofuranylene group, a benzothiophenylene group, a dibenzofuranylene group, a dibenzothiophenylene group, a benzocarbazolylene group, a dibenzocarbazolylene group, a dibenzosilolylene group, a pyridinylene group, an imidazolylene group, a pyrazolylene group, a thiazolylene group, an isothiazolylene group, an oxazolylene group, an isoxazolylene group, a thiadiazolylene group, an oxadiazolylene group, a pyrazinylene group, a pyrimidinylene group, a pyridazinylene group, a triazinylene group, a quinolinylene group, an isoquinolinylene group, a benzoquinolinylene group, a phthalazinylene group, a naphthyridinylene group, a quinoxalinylene group, a quinazolinylene group, a cinnolinylene group, a phenanthridinylene group, an acridinylene group, a phenanthrolinylene group, a phenazinylene group, a benzimidazolylene group, an isobenzothiazolylene group, a benzoxazolylene group, an isobenzoxazolylene group, a triazolylene group, a tetrazolylene group, an imidazopyridinylene group, an imidazopyrimidinylene group, and an azacarbazolylene group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group,
but embodiments of the present disclosure are not limited thereto.

In one or more embodiments, xe1 and xe611 to xe613 in Formulae 601 and 601-1 may each independently be 0, 1, or 2.

For example, R₆₀₁ and R₆₁₁ to R₆₁₃ in Formulae 601 and 601-1 may each independently be selected from: a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₃₀ aryl group, a substituted or unsubstituted C₆-C₃₀ aryloxy group, a substituted or unsubstituted C₆-C₃₀ arylthio group, a substituted or unsubstituted C₁-C₂₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂).

In one or more embodiments, R₆₀₁ and R₆₁₁ to R₆₁₃ in Formulae 601 and 601-1 may each independently be selected from:
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group;
a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group, each substituted with at least one selected from deuterium, -F, -Cl, -Br, -I, a hydroxyl group, a cyano group, a nitro group, an amidino group, a hydrazino group, a hydrazono group, a C₁-C₂₀ alkyl group, a C₁-C₂₀ alkoxy group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a fluoranthenyl group, a triphenylenyl group, a pyrenyl group, a chrysenyl group, a perylenyl group, a pentaphenyl group, a hexacenyl group, a pentacenyl group, a thiophenyl group, a furanyl group, a carbazolyl group, an indolyl group, an isoindolyl group, a benzofuranyl group, a benzothiophenyl group, a dibenzofuranyl group, a dibenzothiophenyl group, a benzocarbazolyl group, a dibenzocarbazolyl group, a dibenzosilolyl group, a pyridinyl group, an imidazolyl group, a pyrazolyl group, a thiazolyl group, an isothiazolyl group, an oxazolyl group, an isoxazolyl group, a thiadiazolyl group, an oxadiazolyl group, a pyrazinyl group, a pyrimidinyl group, a pyridazinyl group, a triazinyl group, a quinolinyl group, an isoquinolinyl group, a benzoquinolinyl group, a phthalazinyl group, a naphthyridinyl group, a quinoxalinyl group, a quinazolinyl group, a cinnolinyl group, a phenanthridinyl group, an acridinyl group, a phenanthrolinyl group, a phenazinyl group, a benzimidazolyl group, an isobenzothiazolyl group, a benzoxazolyl group, an isobenzoxazolyl group, a triazolyl group, a tetrazolyl group, an imidazopyridinyl group, an imidazopyrimidinyl group, and an azacarbazolyl group; and
-S(=O)₂(Q₆₀₁) and -P(=O)(Q₆₀₁)(Q₆₀₂),
wherein Q₆₀₁ and Q₆₀₂ are the same as described above.

The electron transport region may include at least one compound selected from Compounds ET1 to ET36, but embodiments of the present disclosure are not limited thereto:

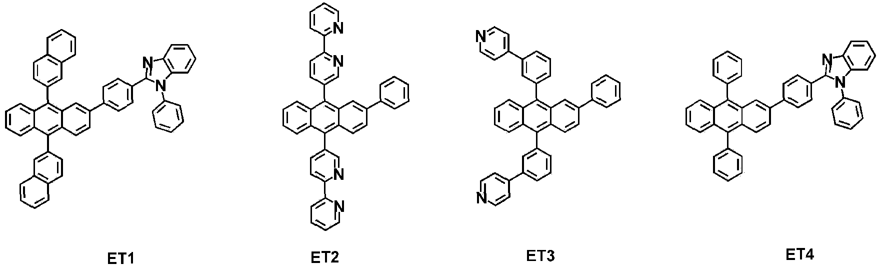

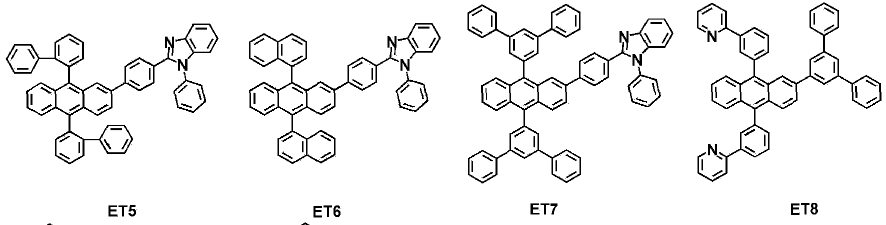

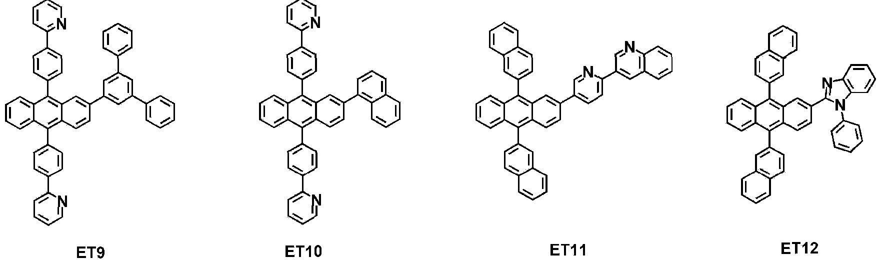

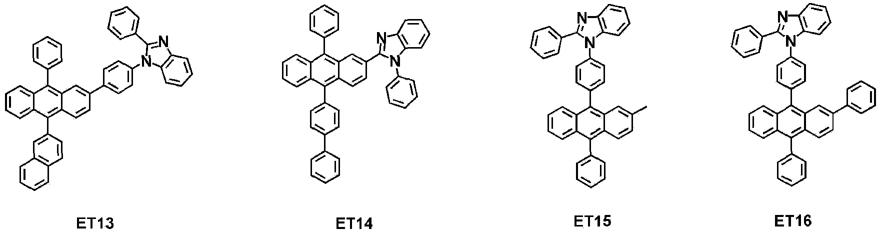

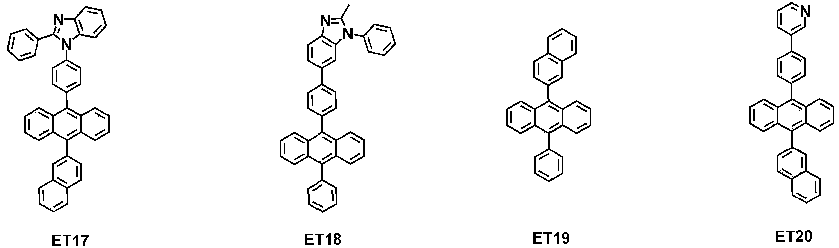

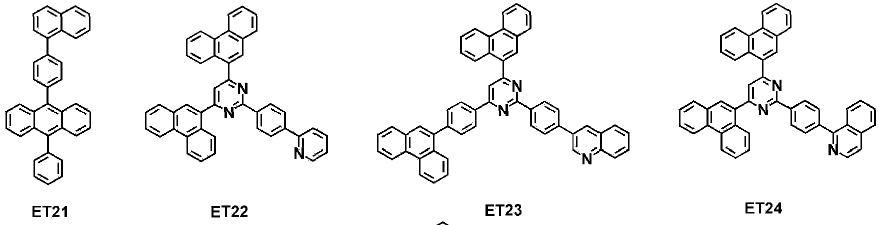

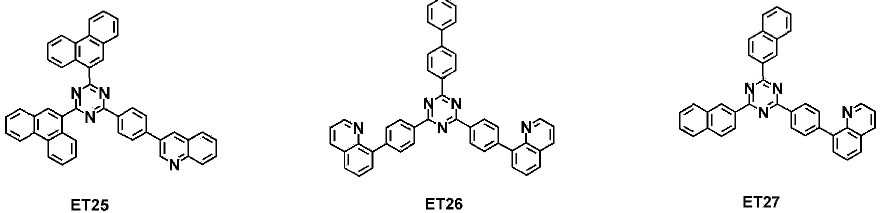

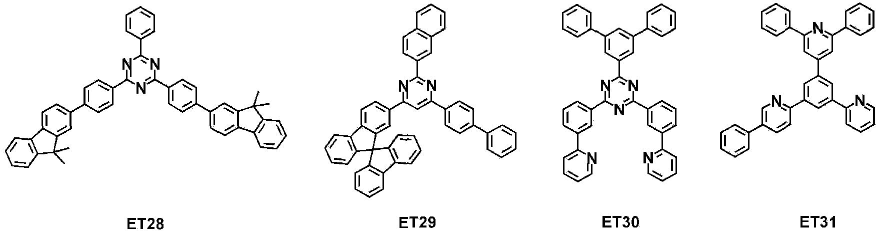

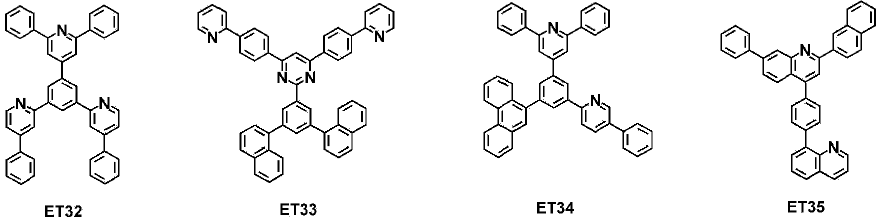

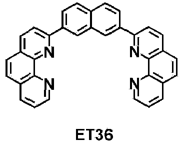

In one or more embodiments, the electron transport region may include at least one compound selected from 2,9-dimethyl-4,7-diphenyl-1,10-phenanthroline (BCP), 4,7-diphenyl-1,10-phenanthroline (Bphen), Alq₃, BAlq, 3-(biphenyl-4-yl)-5-(4-tert-butylphenyl)-4-phenyl-4H-1,2,4-triazole (TAZ), and NTAZ.

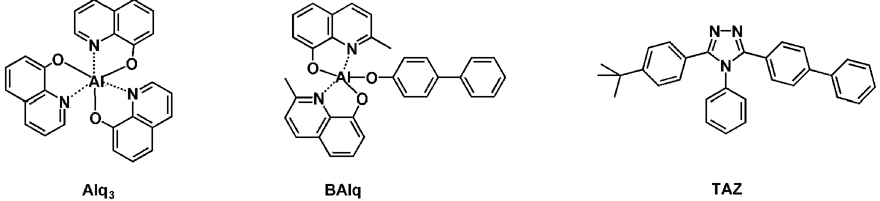

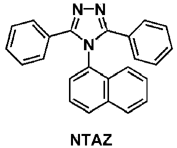

Thicknesses of the buffer layer, the hole blocking layer, and the electron control layer may each independently be in a range of about 20 Å to about 1,000 Å, for example, about 30 Å to about 300 Å. When the thicknesses of the buffer layer, the hole blocking layer, and the electron control layer are each independently within any of these ranges, excellent (or improved) hole blocking characteristics and/or excellent (or improved) electron control characteristics may be obtained without a substantial increase in driving voltage.

A thickness of the electron transport layer may be in a range of about 100 Å to about 1,000 Å, for example, about 150 Å to about 500 Å. When the thickness of the electron transport layer is within the range described above, the electron transport layer may have satisfactory (or suitable) electron transport characteristics without a substantial increase in driving voltage.

The electron transport region (for example, the electron transport layer in the electron transport region) may further include, in addition to the materials described above, a metal-containing material.

The metal-containing material may include at least one selected from an alkali metal complex and an alkaline earth-metal complex. The alkali metal complex may include a metal ion selected from a Li ion, a Na ion, a K ion, a Rb ion, and a Cs ion, and the alkaline earth-metal complex may include a metal ion selected from a Be ion, a Mg ion, a Ca ion, a Sr ion, and a Ba ion. A ligand coordinated with the metal ion of the alkali metal complex or the alkaline earth-metal complex may be selected from a hydroxy quinoline, a hydroxy isoquinoline, a hydroxy benzoquinoline, a hydroxy acridine, a hydroxy phenanthridine, a hydroxy phenyloxazole, a hydroxy phenylthiazole, a hydroxy diphenyloxadiazole, a hydroxy diphenylthiadiazole, a hydroxy phenylpyridine, a hydroxy phenylbenzimidazole, a hydroxy phenylbenzothiazole, a bipyridine, a phenanthroline, and a cyclopentadiene, but embodiments of the present disclosure are not limited thereto.

For example, the metal-containing material may include a Li complex. The Li complex may include, for example, Compound ET-D1 (lithium quinolate, LiQ) and/or Compound ET-D2:

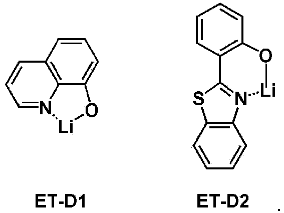

The electron transport region may include an electron injection layer that facilitates electron injection from the second electrode 190. The electron injection layer may directly contact the second electrode 190.

The electron injection layer may have i) a single-layered structure including (e.g., consisting of) a single layer including (e.g., consisting of) a single material, ii) a single-layered structure including (e.g., consisting of) a single layer including (e.g., consisting of) a plurality of different materials, or iii) a multi-layered structure having a plurality of layers including (e.g., consisting of) a plurality of different materials.

The electron injection layer may include an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof.

The alkali metal may be selected from Li, Na, K, Rb, and Cs. In one or more embodiments, the alkali metal may be Li, Na, or Cs. In one or more embodiments, the alkali metal may be Li or Cs, but embodiments of the present disclosure are not limited thereto.

The alkaline earth metal may be selected from Mg, Ca, Sr, and Ba.

The rare earth metal may be selected from Sc, Y, Ce, Yb, Gd, and Tb.

The alkali metal compound, the alkaline earth-metal compound, and the rare earth metal compound may be selected from oxides and halides (for example, fluorides, chlorides, bromides, and/or iodides) of the alkali metal, the alkaline earth metal, and the rare earth metal, respectively.

The alkali metal compound may be selected from alkali metal oxides (such as Li₂O, Cs₂O, and/or K₂O), and alkali metal halides (such as LiF, NaF, CsF, KF, Lil, Nal, CsI, KI, and/or Rbl). In one or more embodiments, the alkali metal compound may be selected from LiF, Li₂O, NaF, Lil, Nal, CsI, and KI, but embodiments of the present disclosure are not limited thereto.

The alkaline earth-metal compound may be selected from alkaline earth-metal oxides, such as BaO, SrO, CaO, BaₓSr₁₋ₓO (0<x<1), and/or BaₓCa₁₋ₓO (0<x<1). In one or more embodiments, the alkaline earth-metal compound may be selected from BaO, SrO, and CaO, but embodiments of the present disclosure are not limited thereto.

The rare earth metal compound may be selected from YbF₃, ScF₃, ScO₃, Sc₂O₃, Y₂O₃, Ce₂O₃, GdF₃, and TbF₃. In one or more embodiments, the rare earth metal compound may be selected from YbF₃, ScF₃, TbF₃, Ybl₃, SCl₃, and Tbl₃, but embodiments of the present disclosure are not limited thereto.

The alkali metal complex, the alkaline earth-metal complex, and the rare earth metal complex may include an ion of alkali metal, alkaline earth metal, and rare earth metal as described above, and a ligand coordinated with a metal ion of the alkali metal complex, the alkaline earth-metal complex, or the rare earth metal complex may be selected from hydroxy quinoline, hydroxy isoquinoline, hydroxy benzoquinoline, hydroxy acridine, hydroxy phenanthridine, hydroxy phenyloxazole, hydroxy phenylthiazole, hydroxy diphenyloxadiazole, hydroxy diphenylthiadiazole, hydroxy phenylpyridine, hydroxy phenylbenzimidazole, hydroxy phenylbenzothiazole, bipyridine, phenanthroline, and cyclopentadiene, but embodiments of the present disclosure are not limited thereto.

The electron injection layer may include (e.g., may consist of) an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof, as described above. In one or more embodiments, the electron injection layer may further include an organic material. When the electron injection layer further includes an organic material, an alkali metal, an alkaline earth metal, a rare earth metal, an alkali metal compound, an alkaline earth-metal compound, a rare earth metal compound, an alkali metal complex, an alkaline earth-metal complex, a rare earth metal complex, or any combination thereof may be homogeneously or non-homogeneously dispersed in a matrix including the organic material.

A thickness of the electron injection layer may be in a range of about 1 Å to about 100 Å, for example, about 3 Å to about 90 Å. When the thickness of the electron injection layer is within the range described above, the electron injection layer may have satisfactory (or suitable) electron injection characteristics without a substantial increase in driving voltage.

### Second electrode 190

The second electrode 190 is located on the organic layer 150 described above. The second electrode 190 may be a cathode, which is an electron injection electrode, and in this regard, a material for forming the second electrode 190 may be selected from a metal, an alloy, an electrically conductive compound, and combinations thereof, which have a relatively low work function.

The second electrode 190 may include at least one selected from lithium (Li), silver (Ag), magnesium (Mg), aluminium (Al), aluminium-lithium (Al-Li), calcium (Ca), magnesium-indium (Mg-In), magnesium-silver (Mg-Ag), ITO, and IZO, but embodiments of the present disclosure are not limited thereto. The second electrode 190 may be a transmissive electrode, a semi-transmissive electrode, or a reflective electrode.

The second electrode 190 may have a single-layered structure or a multi-layered structure including two or more layers.

Meanwhile, the organic light-emitting devices 10, 20, 30, and 40 may each further include at least one selected from a first capping layer located under the first electrode and a second capping layer located on the second electrode.

Light generated in an emission layer of the organic layer 150 of each of the organic light-emitting devices 10, 20, 30, and 40 may be extracted toward the outside through the first electrode 110 and the first capping layer, each of which may be a semi-transmissive electrode or a transmissive electrode, and/or light generated in an emission layer of the organic layer 150 of each of the organic light-emitting devices 10, 20, 30, and 40 may be extracted toward the outside through the second electrode 190 and the second capping layer, each of which may be a semi-transmissive electrode or a transmissive electrode.

The first capping layer and the second capping layer may increase external luminescence efficiency according to the principle of constructive interference.

The first capping layer and the second capping layer may each independently be an organic capping layer including (e.g., consisting of) an organic material, an inorganic capping layer including (e.g., consisting of) an inorganic material, or a composite capping layer including an organic material and an inorganic material.

At least one selected from the first capping layer and the second capping layer may each independently include at least one material selected from carbocyclic compounds, heterocyclic compounds, amine-based compounds, porphyrine derivatives, phthalocyanine derivatives, naphthalocyanine derivatives, alkali metal complexes, and alkaline earth-metal complexes. The carbocyclic compound, the heterocyclic compound, and the amine-based compound may each independently be optionally substituted with a substituent containing at least one element selected from O, N, S, Se, Si, F, Cl, Br, and I. In one or more embodiments, at least one selected from the first capping layer and the second capping layer may each independently include an amine-based compound.

In one or more embodiments, at least one selected from the first capping layer and the second capping layer may each independently include the compound represented by Formula 201 or the compound represented by Formula 202.

In one or more embodiments, at least one selected from the first capping layer and the second capping layer may each independently include a compound selected from Compounds HT28 to HT33 and Compounds CP1 to CP5, but embodiments of the present disclosure are not limited thereto:

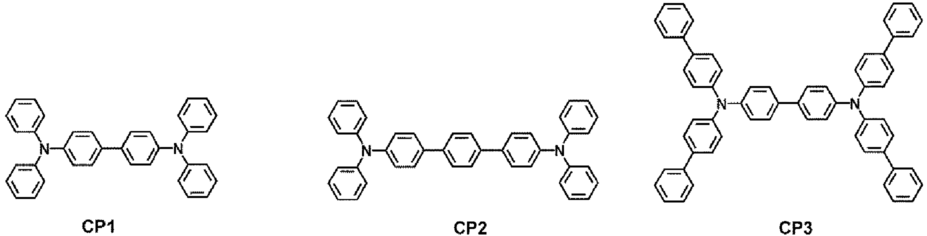

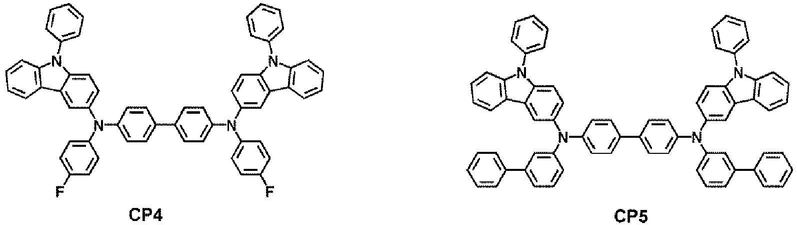

Hereinbefore, the organic light-emitting device according to an embodiment has been described in connection with FIGS. 1 to 4. However, embodiments of the present disclosure are not limited thereto.

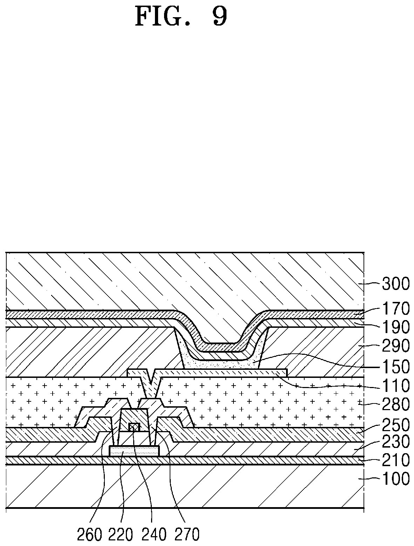

### [Description of FIG. 9]

FIG. 9 is a cross-sectional view showing a light-emitting apparatus according to an embodiment of the present disclosure.

The light-emitting apparatus of FIG. 9 includes a substrate 100, a thin-film transistor (TFT), a light-emitting device, and an encapsulation portion 300 that seals light-emitting device.

The substrate 100 may be a flexible substrate, a glass substrate, or a metal substrate. A buffer layer 210 may be located on the substrate 100. The buffer layer 210 prevents or reduces the penetration of impurities through the substrate 100 and may provide a flat surface on the substrate 100.

A TFT may be located on the buffer layer 210. The TFT may include an activation layer (e.g., an active layer) 220, a gate electrode 240, a source electrode 260, and a drain electrode 270.

The activation layer 220 may include an inorganic semiconductor such as silicon or polysilicon, an organic semiconductor, or an oxide semiconductor, and may include a source region, a drain region and a channel region.

A gate insulating film 230 for insulating the activation layer 220 from the gate electrode 240 may be located on the activation layer 220, and the gate electrode 240 may be located on the gate insulating film 230.

An interlayer insulating film 250 may be located on the gate electrode 240. The interlayer insulating film 250 may be located between the gate electrode 240 and the source electrode 260 to insulate the gate electrode 240 from the source electrode 260 and between the gate electrode 240 and the drain electrode 270 to insulate the gate electrode 240 from the drain electrode 270.

The source electrode 260 and the drain electrode 270 may be located on the interlayer insulating film 250. The interlayer insulating film 250 and the gate insulating film 230 may be formed to expose the source region and the drain region of the activation layer 220, and the source electrode 260 and the drain electrode 270 may be located to be in contact with the exposed portions of the source region and the drain region of the activation layer 220.

The TFT may be electrically connected to the light-emitting device to drive the light-emitting device, and may be covered by a passivation layer 280. The passivation layer 280 may include an inorganic insulating film, an organic insulating film, or a combination thereof. The light-emitting device may be provided on the passivation layer 280. The light-emitting device includes the first electrode 110, the organic layer 150, and the second electrode 190.

The first electrode 110 may be located on the passivation layer 280. The passivation layer 280 does not completely cover the drain electrode 270 and exposes a portion of the drain electrode 270, and the first electrode 110 may be connected to the exposed portion of the drain electrode 270.

A pixel defining layer 290 including an insulating material may be located on the first electrode 110. The pixel defining layer 290 may expose a certain region of the first electrode 110, and the organic layer 150 may be formed in the exposed region of the first electrode 110. The pixel defining layer 290 may be a polyimide-based organic film and/or a polyacryl-based organic film. In an embodiment, at least one or more portions or layers of the organic layer 150 may extend beyond the upper portion of the pixel defining layer 290 and may thus be located in the form of a common layer.

The second electrode 190 may be located on the organic layer 150, and a capping layer 170 may be additionally formed on the second electrode 190. The capping layer 170 may be formed to cover the second electrode 190.

The encapsulation portion 300 may be located on the capping layer 170. The encapsulation portion 300 may be located on a light-emitting device and protects the light-emitting device from moisture or oxygen. The encapsulation portion 300 may include: an inorganic film including silicon nitride (SiNx), silicon oxide (SiOx), indium tin oxide, indium zinc oxide, or a combination thereof; an organic film including polyethylene terephthalate, polyethylene naphthalate, polycarbonate, polyimide, polyethylene sulfonate, polyoxymethylene, polyarylate, hexamethyldisiloxane, an acrylic resin (for example, polymethyl methacrylate and/or polyacrylic acid), an epoxy-based resin (for example, aliphatic glycidyl ether (AGE), or a combination thereof; or a combination of an inorganic film and an organic film.

Layers constituting the hole transport region, the emission layer, and layers constituting the electron transport region may each independently be formed in a certain region by using one or more suitable methods selected from vacuum deposition, spin coating, casting, Langmuir-Blodgett (LB) deposition, ink-jet printing, laser-printing, and laser-induced thermal imaging.

When any of the layers constituting the hole transport region, the emission layer, and the electron transport region are formed by vacuum deposition, the deposition may be performed at a deposition temperature of about 100°C to about 500°C, a vacuum degree of about 10⁻⁸ torr to about 10⁻³ torr, and a deposition speed of about 0.01 Å/sec to about 100 Å/sec by taking into account a material to be included in a layer to be formed and the structure of a layer to be formed.

When any of the layers constituting the hole transport region, the emission layer, and the electron transport region are formed by spin coating, the spin coating may be performed at a coating speed of about 2,000 rpm to about 5,000 rpm and at a heat treatment temperature of about 80°C to 200°C by taking into account a material to be included in a layer to be formed and the structure of a layer to be formed.

### General definition of substituents

The term "C₁-C₆₀ alkyl group" as used herein refers to a linear or branched aliphatic saturated hydrocarbon monovalent group having 1 to 60 carbon atoms, and non-limiting examples thereof include a methyl group, an ethyl group, a propyl group, an isobutyl group, a sec-butyl group, a tert-butyl group, a pentyl group, an isoamyl group, and a hexyl group. The term "C₁-C₆₀ alkylene group" as used herein refers to a divalent group having the same structure as the C₁-C₆₀ alkyl group. Corresponding definitions apply to other ranges given for the number of carbon atoms in an alkyl/alkylene group.

The term "C₂-C₆₀ alkenyl group" as used herein refers to a hydrocarbon group having at least one carbon-carbon double bond in the middle and/or at either terminus of the C₂-C₆₀ alkyl group, and non-limiting examples thereof include an ethenyl group, a propenyl group, and a butenyl group. The term "C₂-C₆₀ alkenylene group" as used herein refers to a divalent group having the same structure as the C₂-C₆₀ alkenyl group. Corresponding definitions apply to other ranges given for the number of carbon atoms in an alkenyl/alkenylene group.

The term "C₂-C₆₀ alkynyl group" as used herein refers to a hydrocarbon group having at least one carbon-carbon triple bond in the middle and/or at either terminus of the C₂-C₆₀ alkyl group, and non-limiting examples thereof include an ethynyl group, and a propynyl group. The term "C₂-C₆₀ alkynylene group" as used herein refers to a divalent group having the same structure as the C₂-C₆₀ alkynyl group. Corresponding definitions apply to other ranges given for the number of carbon atoms in an alkynyl/alkynylene group.

The term "C₁-C₆₀ alkoxy group" as used herein refers to a monovalent group represented by -OA₁₀₁ (wherein A₁₀₁ is the C₁-C₆₀ alkyl group), and non-limiting examples thereof include a methoxy group, an ethoxy group, and an isopropyloxy group. Corresponding definitions apply to other ranges given for the number of carbon atoms in an alkoxy group.

The term "C₃-C₁₀ cycloalkyl group" as used herein refers to a monovalent saturated hydrocarbon monocyclic group having 3 to 10 carbon atoms, and non-limiting examples thereof include a cyclopropyl group, a cyclobutyl group, a cyclopentyl group, a cyclohexyl group, and a cycloheptyl group. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent monocyclic group having at least one heteroatom selected from N, O, Si, P, and S as a ring-forming atom and 1 to 10 carbon atoms as the remaining ring-forming atoms, and non-limiting examples thereof include a 1,2,3,4-oxatriazolidinyl group, a tetrahydrofuranyl group, and a tetrahydrothiophenyl group. The term "C₁-C₁₀ heterocycloalkylene group" as used herein refers to a divalent group having the same structure as the C₁-C₁₀ heterocycloalkyl group.

The term "C₃-C₁₀ cycloalkenyl group" used herein refers to a monovalent monocyclic group that has 3 to 10 carbon atoms and at least one carbon-carbon double bond in the ring thereof and no aromaticity, and non-limiting examples thereof include a cyclopentenyl group, a cyclohexenyl group, and a cycloheptenyl group. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from N, O, Si, P, and S as a ring-forming atom, 1 to 10 carbon atoms as the remaining ring-forming atoms, and at least one carbon-carbon double bond in its ring. Non-limiting examples of the C₁-C₁₀ heterocycloalkenyl group include a 4,5-dihydro-1,2,3,4-oxatriazolyl group, a 2,3-dihydrofuranyl group, and a 2,3-dihydrothiophenyl group. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group having a carbocyclic aromatic system having 6 to 60 carbon atoms. Non-limiting examples of the C₆-C₆₀ aryl group include a phenyl group, a naphthyl group, an anthracenyl group, a phenanthrenyl group, a pyrenyl group, and a chrysenyl group. The term "C₆-C₆₀ arylene group" used herein refers to a divalent group having the same structure as the C₆-C₆₀ aryl group. When the C₆-C₆₀ aryl group and the C₆-C₆₀ arylene group each independently include two or more rings, the respective two or more rings may be fused to each other. Corresponding definitions apply to other ranges given for the number of carbon atoms in an aryl/arylene group.

The term "C₁-C₆₀ heteroaryl group" as used herein refers to a monovalent group having a heterocyclic aromatic system that has at least one heteroatom selected from N, O, Si, P, and S as a ring-forming atom, in addition to 1 to 60 carbon atoms. Non-limiting examples of the C₁-C₆₀ heteroaryl group include a pyridinyl group, a pyrimidinyl group, a pyrazinyl group, a pyridazinyl group, a triazinyl group, a quinolinyl group, and an isoquinolinyl group. The term "C₁-C₆₀ heteroarylene group" as used herein refers to a divalent group having the same structure as the C₁-C₆₀ heteroaryl group. When the C₁-C₆₀ heteroaryl group and the C₁-C₆₀ heteroarylene group each independently include two or more rings, the respective two or more rings may be condensed (e.g., fused) with each other. Corresponding definitions apply to other ranges given for the number of carbon atoms in an heteroaryl/heteroarylene group.

The term "C₆-C₆₀ aryloxy group" as used herein refers to a monovalent group represented by -OA₁₀₂ (wherein A₁₀₂ is the C₆-C₆₀ aryl group), and a C₆-C₆₀ arylthio group used herein refers to a monovalent group represented by -SA₁₀₃ (wherein A₁₀₃ is the C₆-C₆₀ aryl group). Corresponding definitions apply to other ranges given for the number of carbon atoms in an aryloxy group and an arylthio group.

The term "monovalent non-aromatic condensed polycyclic group" as used herein refers to a monovalent group having two or more rings condensed with each other, only carbon atoms as ring-forming atoms (e.g., 8 to 60 carbon atoms), and no aromaticity in its entire molecular structure (e.g., the molecular structure as a whole is non-aromatic). A non-limiting example of the monovalent non-aromatic condensed polycyclic group is a fluorenyl group. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group having two or more rings condensed to each other, at least one heteroatom selected from N, O, Si, P, and S, other than carbon atoms (e.g., 1 to 60 carbon atoms), as a ring-forming atom, and no aromaticity in its entire molecular structure (e.g., the molecular structure as a whole is non-aromatic). A non-limiting example of the monovalent non-aromatic condensed heteropolycyclic group is a carbazolyl group. The term "divalent non-aromatic condensed heteropolycyclic group" as used herein refers to a divalent group having the same structure as the monovalent non-aromatic condensed heteropolycyclic group.

The term "C₅-C₆₀ carbocyclic group" as used herein refers to a monocyclic or polycyclic group that includes only carbon atoms as ring-forming atoms and consists of 5 to 60 carbon atoms. The C₅-C₆₀ carbocyclic group may be an aromatic carbocyclic group or a non-aromatic carbocyclic group. The C₅-C₆₀ carbocyclic group may be a ring (such as benzene), a monovalent group (such as a phenyl group), or a divalent group (such as a phenylene group). In one or more embodiments, depending on the number of substituents connected to the C₅-C₆₀ carbocyclic group, the C₅-C₆₀ carbocyclic group may be a trivalent group or a quadrivalent group. Corresponding definitions apply to other ranges given for the number of carbon atoms in a carbocyclic group.

The term "C₁-C₆₀ heterocyclic group" as used herein refers to a group having the same structure as the C₅-C₆₀ carbocyclic group, except that as a ring-forming atom, at least one heteroatom selected from N, O, Si, P, and S is used in addition to carbon atoms (the number of carbon atoms may be in a range of 1 to 60). Corresponding definitions apply to other ranges given for the number of carbon atoms in a heterocyclic group.

In the present specification, at least one substituent of the substituted C₅-C₆₀ (*e.g*. C₅-C₃₀) carbocyclic group, the substituted C₁-C₆₀ (*e.g*. C₁-C₂₀) heterocyclic group, the substituted C₃-C₁₀ cycloalkylene group, the substituted C₁-C₁₀ heterocycloalkylene group, the substituted C₃-C₁₀ cycloalkenylene group, the substituted C₁-C₁₀ heterocycloalkenylene group, the substituted C₆-C₆₀ (*e.g*. C₆-C₃₀) arylene group, the substituted C₁-C₆₀ (*e.g*. C₁-C₂₀) heteroarylene group, the substituted divalent non-aromatic condensed polycyclic group, the substituted divalent non-aromatic condensed heteropolycyclic group, the substituted C₁-C₆₀ (*e.g*. C₁-C₂₀) alkyl group, the substituted C₂-C₆₀ (*e.g*. C₂-C₂₀) alkenyl group, the substituted C₂-C₆₀ (*e.g*. C₂-C₂₀) alkynyl group, the substituted C₁-C₆₀ (*e.g*. C₁-C₂₀) alkoxy group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ (*e.g*. C₆-C₃₀) aryl group, the substituted C₆-C₆₀ (*e.g*. C₆-C₃₀) aryloxy group, the substituted C₆-C₆₀ (*e.g*. C₆-C₃₀) arylthio group, the substituted C₁-C₆₀ (*e.g*. C₁-C₂₀) heteroaryl group, the substituted monovalent non-aromatic condensed polycyclic group, and the substituted monovalent non-aromatic condensed heteropolycyclic group may be selected from:
deuterium (-D), -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ (*e.g*. C₂-C₂₀) alkenyl group, a C₂-C₆₀ (*e.g*. C₂-C₂₀) alkynyl group, and a C₁-C₆₀ (e.g. C₁-C₂₀) alkoxy group;
a C₁-C₆₀ (*e.g*. C₁-C₂₀) alkyl group, a C₂-C₆₀ (*e.g*. C₂-C₂₀) alkenyl group, a C₂-C₆₀ (*e.g*. C₂-C₂₀) alkynyl group, and a C₁-C₆₀ (*e.g*. C₁-C₂₀) alkoxy group, each substituted with at least one selected from deuterium, -F, -Cl, -Br, -I, a hydroxyl group, a cyano group, a nitro group, an amidino group, a hydrazino group, a hydrazono group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g*. C₆-C₃₀) aryloxy group, a C₆-C₆₀ (*e.g*. C₆-C₃₀) arylthio group, a C₁-C₆₀ (*e.g*. C₁-C₂₀) heteroaryl group, a monovalent non-aromatic condensed polycyclic group, a monovalent non-aromatic condensed heteropolycyclic group, -Si(Q₁₁)(Q₁₂)(Q₁₃), - N(Q₁₁)(Q₁₂), -B(Q₁₁)(Q₁₂), -C(=O)(Q₁₁), -S(=O)₂(Q₁₁), and -P(=O)(Q₁₁)(Q₁₂);
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g.* C₆-C₃₀) aryloxy group, a C₆-C₆₀ (*e.g*. C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g*. C₆-C₃₀) aryloxy group, a C₆-C₆₀ (*e.g*. C₆-C₃₀) arylthio group, a C₁-C₆₀ (*e.g*. C₁-C₂₀) heteroaryl group, a monovalent non-aromatic condensed polycyclic group, and a monovalent non-aromatic condensed heteropolycyclic group, each substituted with at least one selected from deuterium, -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ (*e.g*. C₂-C₂₀) alkenyl group, a C₂-C₆₀ (*e.g*. C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₆-C₆₀ (*e.g*. C₆-C₃₀) aryloxy group, a C₆-C₆₀ (*e.g*. C₆-C₃₀) arylthio group, a C₁-C₆₀ (*e.g*. C₁-C₂₀) heteroaryl group, a monovalent non-aromatic condensed polycyclic group, a monovalent non-aromatic condensed heteropolycyclic group, -Si(Q₂₁)(Q₂₂)(Q₂₃), -N(Q₂₁)(Q₂₂), - B(Q₂₁)(Q₂₂), -C(=O)(Q₂₁), -S(=O)₂(Q₂₁), and -P(=O)(Q₂₁)(Q₂₂), and
-Si(Q₃₁)(Q₃₂)(Q₃₃), -N(Q₃₁)(Q₃₂), -B(Q₃₁)(Q₃₂), -C(=O)(Q₃₁), -S(=O)₂(Q₃₁), and -P(=O)(Q₃₁)(Q₃₂),
wherein Q₁₁ to Q₁₃, Q₂₁ to Q₂₃, and Q₃₁ to Q₃₃ may each independently be selected from hydrogen, deuterium, -F, -Cl, -Br, -I, a hydroxyl group, a cyano group, a nitro group, an amidino group, a hydrazino group, a hydrazono group, a C₁-C₆₀ (*e.g*. C₁-C₂₀) alkyl group, a C₂-C₆₀ (*e.g*. C₂-C₂₀) alkenyl group, a C₂-C₆₀ (*e.g*. C₂-C₂₀) alkynyl group, a C₁-C₆₀ (*e.g*. C₁-C₂₀) alkoxy group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ (*e.g*. C₆-C₃₀) aryl group, a C₁-C₆₀ (*e.g*. C₁-C₂₀) heteroaryl group, a monovalent non-aromatic condensed polycyclic group, a monovalent non-aromatic condensed heteropolycyclic group, a biphenyl group, and a terphenyl group.

The term "Ph" as used herein refers to a phenyl group, the term "Me" as used herein refers to a methyl group, the term "Et" as used herein refers to an ethyl group, the term "ter-Bu" or "Bu^{t}" as used herein refers to a tert-butyl group, and the term "OMe" as used herein refers to a methoxy group.

The term "biphenyl group" as used herein refers to "a phenyl group substituted with a phenyl group". For example, the "biphenyl group" may be "a substituted phenyl group" having a "C₆-C₆₀ aryl group" as a substituent.

The term "terphenyl group" as used herein refers to "a phenyl group substituted with a biphenyl group". For example, the "terphenyl group" may be a "substituted phenyl group" having, as a substituent, a "C₆-C₆₀ aryl group substituted with a C₆-C₆₀ aryl group".

* and *' as used herein, unless defined otherwise, each refer to a binding site to a neighboring atom in a corresponding formula.

Hereinafter, an organic light-emitting device according to embodiments will be described in more detail with reference to Examples.

### Examples

### Comparative Example 1

As substrates and anodes, each of a first glass substrate (in which 150/cm² (100Å) ITO available from Corning, Inc. is formed), a second glass substrate (in which (1000Å) Ag is formed), and a third glass substrate (in which 150/cm² (100Å) ITO available from Corning, Inc. is formed) was cut to a size of 50 mm x 50 mm x 0.7 mm, sonicated with isopropyl alcohol and pure water each for 5 minutes, and then cleaned by irradiation of ultraviolet rays and exposure to ozone for 30 minutes. Then, the first glass substrate to the third glass substrate were sequentially stacked to form an anode and loaded onto a vacuum deposition apparatus.

HT3 and F4-TCNQ were deposited at a weight ratio of 9 : 1 on the anode to form a hole injection layer having a thickness of 100 Å.

HT3 was deposited on the hole injection layer to form a hole transport layer having a thickness of 100 Å.

HT18 (50 Å) was deposited on the hole transport layer to form a HT-auxiliary layer, and H8 and FD5 (here, an amount of FD5 is 1 wt%) were co-deposited thereon to form an emission layer having a thickness of 190 Å, thereby completing the formation of a first emission unit.

ET28 (50 Å) was deposited on the first emission unit to form an ET-auxiliary layer.

ET1 and LiQ were deposited at a weight ratio of 5 : 5 on the ET-auxiliary layer to form an electron transport layer having a thickness of 250 Å.

ET 36 and Yb (here, an amount of Yb is 5 wt%) were co-deposited on the electron transport layer to form an n-type charge generating layer having a thickness of 150 Å, and F4-TCNQ (100 Å) was deposited thereon to form a p-type charge generating layer, thereby completing the formation of a first charge generating layer.

HT3 (430 Å) was deposited on the first charge generating layer to form a hole transport layer.

HT18 (50 Å) was deposited on the hole transport layer to form a HT-auxiliary layer, and H8 and FD5 (here, an amount of FD5 is 1 wt%) were co-deposited thereon to form an emission layer having a thickness of 190 Å, thereby completing the formation of a second emission unit.

ET28 (50 Å) was deposited on the second emission unit to form an ET-auxiliary layer.

ET1 and LiQ were deposited at a weight ratio of 5 : 5 on the ET-auxiliary layer to form an electron transport layer having a thickness of 250 Å.

Yb (15 Å) was deposited on the electron transport layer to form an electron injection layer, thereby completing the formation of an electron transport region.

Ag and Mg (a weight ratio of 5:5) (100 Å) was deposited on the electron transport region to form a cathode, and HT28 (600 Å) was deposited on the cathode to form a capping layer, thereby completing the manufacture of an organic light-emitting device.

### Example 1

An organic light-emitting device was manufactured in substantially the same manner as in Comparative Example 1, except that a material for the p-type charge generating layer was changed to HT3 and Bi₂Te₃ (here, an amount of Bi₂Te₃ is 5 wt%), Bi₂Te₃ (5 Å) was deposited as an interlayer on the n-type charge generating layer before the p-type charge generating layer was deposited on the n-type charge generating layer, and the p-type charge generating layer (100 Å) was deposited on the interlayer.

### Example 2

An organic light-emitting device was manufactured in substantially the same manner as in Example 1, except that the amount of Bi₂Te₃ in the p-type charge generating layer was changed to 10 wt%.

### Example 3

An organic light-emitting device was manufactured in substantially the same manner as in Example 1, except that the amount of Bi₂Te₃ in the p-type charge generating layer was changed to 15 wt%.

### Example 4

An organic light-emitting device was manufactured in substantially the same manner as in Example 1, except that the thickness of the interlayer was changed to 15 Å.

### Example 5

An organic light-emitting device was manufactured in substantially the same manner as in Example 2, except that the thickness of the interlayer was changed to 15 Å.

### Example 6

An organic light-emitting device was manufactured in substantially the same manner as in Example 3, except that the thickness of the interlayer was changed to 15 Å.

### Comparative Example 2

An organic light-emitting device was manufactured in substantially the same manner as in Example 1, except that the material for the p-type charge generating layer was changed to an alloy of Yb and Te (amount: 10 wt%).

### Comparative Example 3

An organic light-emitting device was manufactured in substantially the same manner as in Example 1, except that the material for the p-type charge generating layer was changed to BiI₃.

### Comparative Example 4

An organic light-emitting device was manufactured in substantially the same manner as in Example 1, except that the material for the p-type charge generating layer was changed into KI (amount: 10 wt%).

### Evaluation Example 1

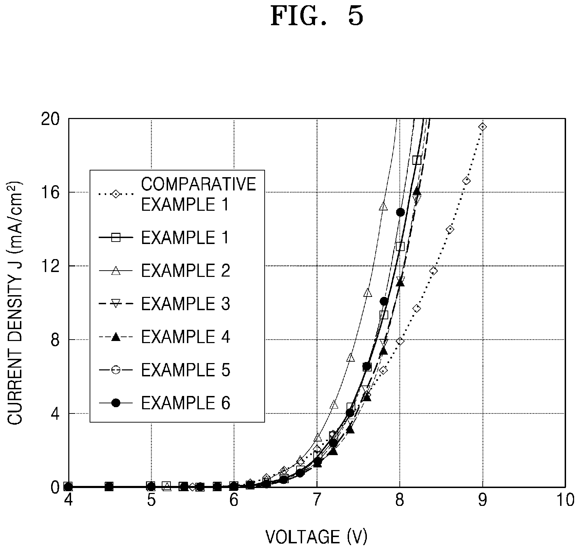

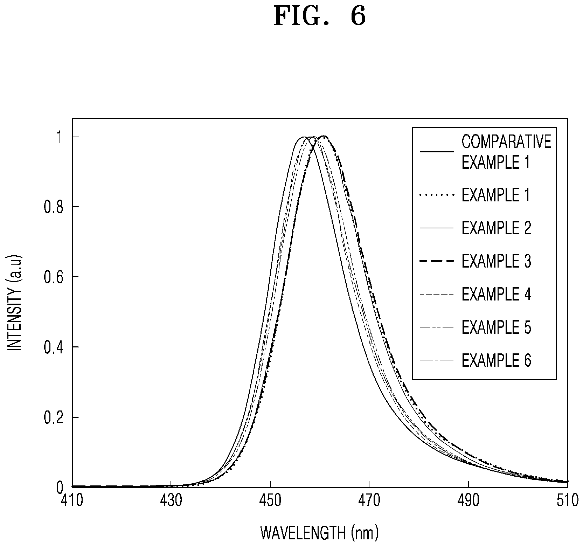

The driving voltage, current density (mA/cm²) at the corresponding voltage, efficiency (Cd/A), white-color emission efficiency (Im/W), color coordinates (CIE_x, CIE_y), and efficiency (Cd/A/y) of the organic light-emitting devices manufactured according to Examples 1 to 6 and Comparative Examples 1 to 4 were measured and are shown in Table 2, and changes in current density according to voltage and maximum emission wavelengths were measured and are shown in FIG. 5 and FIG. 6, respectively.

**Table 2**

| | Driving voltage( V) | Current density (mA/cm²) | Efficienc y (Cd/A) | White-color emission efficiency (Im/W) | CIE_x | CIE_y | Efficienc y/y (Cd/A/y) |
|---|---|---|---|---|---|---|---|
| Examp le 1 | 7.92 | 11.5 | 10.7 | 4.3 | 0.136 | 0.056 | 191.2 |
| Examp le 2 | 7.65 | 10.5 | 10.2 | 4.2 | 0.139 | 0.049 | 207.6 |
| Examp le 3 | 8.11 | 13.9 | 8.0 | 3.1 | 0.138 | 0.051 | 157.6 |
| Examp le 4 | 8.13 | 15.1 | 6.4 | 2.5 | 0.142 | 0.045 | 143.3 |
| Examp le 5 | 7.89 | 13.2 | 7.7 | 3.0 | 0.141 | 0.046 | 164.7 |
| Examp le 6 | 7.99 | 13.6 | 7.4 | 2.9 | 0.141 | 0.046 | 160.5 |
| Compa rative Examp le 1 | 8.65 | 14.7 | 7.9 | 2.9 | 0.135 | 0.053 | 148.9 |
| Compa rative Examp le 2 | 19.8 | 18.4 | 9.4 | 1.6 | 0.127 | 0.071 | 132.4 |
| Compa rative Examp le 3 | 8.96 | 19.9 | 5.8 | 2.2 | 0.138 | 0.052 | 111.5 |
| Compa rative Example 4 | 15.8 | 17.6 | 10.5 | 2.3 | 0.128 | 0.068 | 154.4 |

Referring to FIGS. 5 and 6 and Table 2, the organic light-emitting devices manufactured according to Examples 1 to 6 may have reduced driving voltage and higher current density at the same voltage, compared to the organic light-emitting devices manufactured according to Comparative Examples 1 to 4 (e.g., with the same (low) voltage as those of the Examples), and may have color purity and emission efficiency that are greater than or equal to or not significantly lower than those of devices in the related art.

For example, referring to FIG. 6, the emission wavelengths of the organic light-emitting device manufactured according to Examples 1 to 6 are not significantly different from those of devices in the related art, and thus blue light may be emitted.

### Example 7

As substrates and anodes, each of a first glass substrate (in which 15Ω/cm² (100Å) ITO available from Corning, Inc. is formed), a second glass substrate (in which (1000Å) Ag is formed), and a third glass substrate (in which 15Ω/cm² (100Å) ITO available from Corning, Inc. is formed) was cut to a size of 50 mm x 50 mm x 0.7 mm, sonicated with isopropyl alcohol and pure water each for 5 minutes, and then cleaned by irradiation of ultraviolet rays and exposure to ozone for 30 minutes. Then, the first glass substrate to the third glass substrate were sequentially stacked to form an anode and loaded onto a vacuum deposition apparatus.

HT3 and F4-TCNQ were deposited at a weight ratio of 9 : 1 on the anode to form a hole injection layer having a thickness of 100 Å.

HT3 was deposited on the hole injection layer to form a hole transport layer.

HT18 (50 Å) was deposited on the hole transport layer to form a HT-auxiliary layer, and H8 and FD5 (here, an amount of FD5 is 1 wt%) were co-deposited thereon to form an emission layer having a thickness of 190 Å, thereby completing the formation of a first emission unit.

ET28 (50 Å) was deposited on the first emission unit to form an ET-auxiliary layer.

ET1 was deposited on the ET-auxiliary layer to form an electron transport layer having a thickness of 200 Å.

ET 36 and Yb (here, an amount of Yb is 1 wt%) were co-deposited on the electron transport layer to form an n-type charge generating layer having a thickness of 150 Å, and HT3 and PbTe (here, an amount of PbTe is 5 wt%) were co-deposited thereon to form a p-type charge generating layer having a thickness of 150 Å, thereby completing the formation of a first charge generating layer.

HT3 (430 Å) was deposited on the first charge generating layer to form a hole transport layer.

HT18 (50 Å) was deposited on the hole transport layer to form a HT-auxiliary layer, and H8 and FD5 (here, an amount of FD5 is 1 wt%) were co-deposited thereon to form an emission layer having a thickness of 190 Å, thereby completing the formation of a second emission unit.

ET28 (50 Å) was deposited on the second emission unit to form an ET-auxiliary layer.

ET1 was deposited on the ET-auxiliary layer to form an electron transport layer having a thickness of 250 Å.

Yb (15 Å) was deposited on the electron transport layer to form an electron injection layer, thereby completing the formation of an electron transport region.

Ag and Mg (a weight ratio of 5:5) (100 Å) was deposited on the electron transport region to form a cathode, and HT28 (600 Å) was deposited on the cathode to form a capping layer, thereby completing the manufacture of an organic light-emitting device.

### Example 8

An organic light-emitting device was manufactured in substantially the same manner as in Example 7, except that 1 wt% of Cul was deposited on the n-type charge generating layer to additionally form an auxiliary layer between the n-type charge generating layer and the p-type charge generating layer, the amount of Cul being based on a total weight of the p-type charge generating layer.

### Example 9

An organic light-emitting device was manufactured in substantially the same manner as in Example 7, except that the p-type charge generating layer further included 1 wt% of Cul, based on a total weight of the p-type charge generating layer.

### Example 10

An organic light-emitting device was manufactured in substantially the same manner as in Example 7, except that the p-type charge generating layer further included 3 wt% of Cul, based on a total weight of the p-type charge generating layer.

### Example 11

An organic light-emitting device was manufactured in substantially the same manner as in Example 7, except that the p-type charge generating layer further included 5 wt% of Cul, based on a total weight of the p-type charge generating layer.

### Example 12

An organic light-emitting device was manufactured in substantially the same manner as in Example 7, except that the p-type charge generating layer further included 7 wt% of Cul, based on a total weight of the p-type charge generating layer.

### Example 13

An organic light-emitting device was manufactured in substantially the same manner as in Example 7, except that the p-type charge generating layer further included 10 wt% of Cul, based on a total weight of the p-type charge generating layer.

### Example 14

An organic light-emitting device was manufactured in substantially the same manner as in Example 8, except that 3 wt% of Cul was deposited to form an auxiliary layer.

### Example 15

An organic light-emitting device was manufactured in substantially the same manner as in Example 8, except that 5 wt% of Cul was deposited to form an auxiliary layer.

### Example 16

An organic light-emitting device was manufactured in substantially the same manner as in Example 8, except that 7 wt% of Cul was deposited to form an auxiliary layer.

### Example 17

An organic light-emitting device was manufactured in substantially the same manner as in Example 8, except that 10 wt% of Cul was deposited to form an auxiliary layer.

### Evaluation Example 2

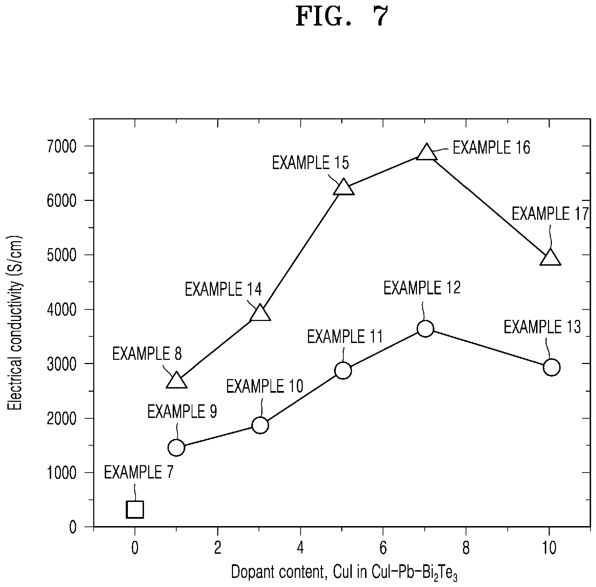

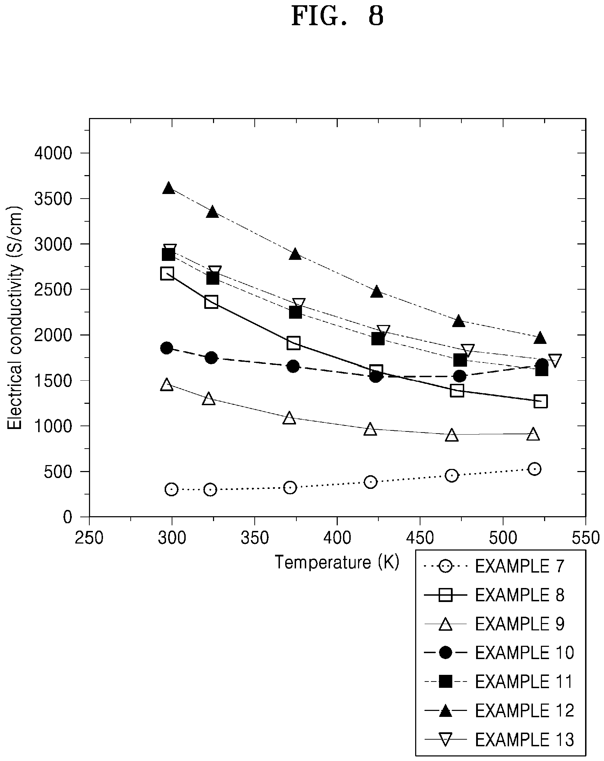

Electrical conductivity and changes in electrical conductivity according to temperature of the organic light-emitting devices manufactured according to Examples 7 to 17 were measured and are shown in FIG. 7 and FIG. 8, respectively.

Referring to FIGS. 7 and 8, the organic light-emitting devices which further include Cul and manufactured according to Examples 8 to 17 have excellent electrical conductivity, compared to the organic light-emitting device manufactured according to Example 7, which does not include Cul.

The organic light-emitting device may have low driving voltage, high efficiency, and long lifespan.

As used herein, the terms "use," "using," and "used" may be considered synonymous with the terms "utilize," "utilizing," and "utilized," respectively.

In addition, the terms "substantially," "about," and similar terms are used as terms of approximation and not as terms of degree, and are intended to account for the inherent deviations in measured or calculated values that would be recognized by those of ordinary skill in the art.

Also, any numerical range recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

## Claims

1. An organic light-emitting device (10, 20, 30, 40) comprising:
a first electrode (110);
a second electrode (190) facing the first electrode (110);
m emission units (153) between the first electrode (110) and the second electrode (190), the m emission units (153) comprising at least one emission layer; and
m-1 charge generating layers (155) between two adjacent emission units among the m emission units (153), each of the m-1 charge generating layers (155) comprising an n-type charge generating layer (155') and a p-type charge generating layer (155"),
wherein m is an integer of 2 or more,
at least one of the m-1 p-type charge generating layers (155") comprises a first inorganic material, wherein the first inorganic material is a compound comprising a post transition metal and a metalloid,
the post transition metal is at least one selected from aluminum (Al), gallium (Ga), indium (In), thallium (TI), tin (Sn), lead (Pb), flerovium (FI), bismuth (Bi), and polonium (Po),
the metalloid is at least one selected from boron (B), silicon (Si), germanium (Ge), arsenic (As), antimony (Sb), tellurium (Te), and astatine (At), and
at least one of the m-1 n-type charge generating layers (155') includes a metal.

2. An organic light-emitting device (10, 20, 30, 40) according claim 1, wherein:
(i) a composition ratio of the post transition metal and the metalloid is from 50:1 to 1:50; and/or
(ii) an absolute value of a work function of the first inorganic material is 3.0 eV or more.

3. An organic light-emitting device (10, 20, 30, 40) according to claim 1 or claim 2, wherein:
(i) the post transition metal is at least one selected from Al, Ga, In, Tl, Sn, Pb, Fl, and Bi; and/or
(ii) the metalloid is at least one selected from Si, Ge, As, Sb, and Te.

4. An organic light-emitting device (10, 20, 30, 40) according to any one of claims 1 to 3, wherein the first inorganic material is at least one selected from Bi₂Te₃, Bi₇Te₃, Bi₂Te, Bi₄Te₃, BiTe, Bi₆Te₇, Bi₄Te₅, BiₓTe_{y} (0<x<100, 0<y<100, 0<x+y≤100), In₂Te₃, Ga₂Te₂, Al₂Te₃, Tl₂Te₃, SnTe, PbTe, FITe, AlInSb, AlGaSb, AlAsSb, GaAs, InSb, AlSb, AlAs, AlₐInₐSb (0<a<1), Al_{b}In_{(1-b)}Sb (0<b<1), AlSb, GaSb, and AllnGaAs.

5. An organic light-emitting device (10, 20, 30, 40) according to any one of claims 1 to 4, wherein a thermal evaporation temperature of the first inorganic material is 1,500 °C or less.

6. An organic light-emitting device (10, 20, 30, 40) according to any one of claims 1 to 5, wherein the m-1 n-type charge generating layers (155') further comprise a metal-free compound comprising at least one π electron-deficient nitrogen-containing ring, a compound represented by Formula 601, a metal oxide, a metal carbide, a metal halide, or any mixture thereof:
Formula 601 [Ar₆₀₁]ₓₑ₁₁-[(L₆₀₁)ₓₑ₁-R₆₀₁]ₓₑ₂₁,
wherein, in Formula 601,
Ar₆₀₁ is a substituted or unsubstituted C₅-C₆₀ carbocyclic group or a substituted or unsubstituted C₁-C₆₀ heterocyclic group,
xe11 is 1, 2, or 3,
L₆₀₁ is selected from a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, and a substituted or unsubstituted divalent non-aromatic condensed heteropolycyclic group,
xe1 is an integer from 0 to 5,
R₆₀₁ is selected from a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted monovalent non-aromatic condensed polycyclic group, a substituted or unsubstituted monovalent non-aromatic condensed heteropolycyclic group, - Si(Q₆₀₁)(Q₆₀₂)(Q₆₀₃), -C(=O)(Q₆₀₁), -S(=O)₂(Q₆₀₁), and -P(=O)(Q₆₀₁)(Q₆₀₂),
Q₆₀₁ to Q₆₀₃ are each independently a C₁-C₁₀ alkyl group, a C₁-C₁₀ alkoxy group, a phenyl group, a biphenyl group, a terphenyl group, or a naphthyl group, and
xe21 is an integer from 1 to 5.

7. An organic light-emitting device (10, 20, 30, 40) according to any one of claims 1 to 6, wherein at least one of the m-1 p-type charge generating layers (155") comprises the first inorganic material and a hole transport material, optionally wherein an amount of the first inorganic material in the at least one of the m-1 p-type charge generating layers (155") is selected in a range of 0.01 parts by weight to 49.9 parts by weight, based on 100 parts by weight of the hole transport material.

8. An organic light-emitting device (20) according to any one of claims 1 to 7, wherein at least one of the m-1 charge generating layers (155) further comprises an interlayer (155a) between the n-type charge generating layer (155') and the p-type charge generating layer (155").

9. An organic light-emitting device (20) according to claim 8, wherein the interlayer (155a) comprises the first inorganic material, optionally wherein at least one of the m-1 n-type charge generating layers (155') and m-1 p-type charge generating layers (155") comprises the first inorganic material that is different from the first inorganic material in the interlayer (155a).

10. An organic light-emitting device (10, 20, 30, 40) according to any one of claims 1 to 9, further comprising a second inorganic material being at least one selected from a halide compound of a transition metal, a halide compound of a late transition metal, and combinations thereof, optionally wherein the second inorganic material is at least one selected from CuF, CuCl, CuBr, Cul, NiF₂, NiCl₂, NiBr₂, NiI₂, ZnF₂, ZnCl₂, ZnBr₂, ZnI₂, ZnF₄, and ZnI₄.

11. An organic light-emitting device (10, 20, 30, 40) according to claim 10, wherein the second inorganic material is in:
i) a charge generating layer from among the n-type charge generating layer and the p-type charge generating layer that comprises the first inorganic material;
ii) an auxiliary layer adjacent to the charge generating layer comprising the first inorganic material; or
iii) the charge generating layer comprising the first inorganic material and the auxiliary layer.

12. An organic light-emitting device (10, 20, 30, 40) according to any one of claims 1 to 11, wherein m is 2 or 3.

13. A flat-display apparatus comprising:
a thin-film transistor comprising a source electrode, a drain electrode, and an activation layer; and
an organic light-emitting device (10, 20, 30, 40) according to any one of claims 1 to 12,
wherein the first electrode (110) of the organic light-emitting device is electrically coupled with one selected from the source electrode and the drain electrode of the thin-film transistor.

## Patentansprüche

1. Organische lichtemittierende Vorrichtung (10, 20, 30, 40), Folgendes umfassend:
eine erste Elektrode (110);
eine zweite Elektrode (190), die der ersten Elektrode (110) zugewandt ist;
m Emissionseinheiten (153) zwischen der ersten Elektrode (110) und der zweiten Elektrode (190), wobei die m Emissionseinheiten (153) mindestens eine Emissionsschicht umfassen; und
m-1 ladungserzeugende Schichten (155) zwischen zwei angrenzenden Emissionseinheiten unter den m Emissionseinheiten (153), wobei jede der m-1 ladungserzeugenden Schichten (155) eine ladungserzeugende Schicht vom n-Typ (155') und eine ladungserzeugende Schicht vom p-Typ (155'') umfasst,
wobei m eine ganze Zahl von 2 oder mehr ist,
mindestens eine der m-1 ladungserzeugenden Schichten vom p-Typ (155'') ein erstes anorganisches Material umfasst, wobei das erste anorganische Material eine Verbindung ist, die ein Post-Übergangsmetall und ein Halbmetall umfasst,
wobei das Post-Übergangsmetall mindestens eines ist, das aus Aluminium (Al), Gallium (Ga), Indium (In), Thallium (Tl), Zinn (Sn), Blei (Pb), Flerovium (Fl), Bismut (Bi) und Polonium (Po) ausgewählt ist,
wobei das Halbmetall mindestens eines ist, das aus Bor (B), Silizium (Si), Germanium (Ge), Arsen (As), Antimon (Sb), Tellur (Te) und Astat (At) ausgewählt ist, und
mindestens eine der m-1 ladungserzeugenden Schichten vom n-Typ (155') ein Metall einschließt.

2. Organische lichtemittierende Vorrichtung (10, 20, 30, 40) nach Anspruch 1, wobei:
(i) ein Zusammensetzungsverhältnis des Post-Übergangsmetalls und des Halbmetalls 50:1 bis 1:50 beträgt; und/oder
(ii) ein absoluter Wert einer Austrittsarbeit des ersten anorganischen Materials 3,0 eV oder mehr beträgt.

3. Organische lichtemittierende Vorrichtung (10, 20, 30, 40) nach Anspruch 1 oder Anspruch 2, wobei:
(i) das Post-Übergangsmetall mindestens eines ist, das aus Al, Ga, In, Tl, Sn, Pb, Fl und Bi ausgewählt ist; und/oder
(ii) das Halbmetall mindestens eines ist, das aus Si, Ge, As, Sb und Te ausgewählt ist.

4. Organische lichtemittierende Vorrichtung (10, 20, 30, 40) nach einem der Ansprüche 1 bis 3, wobei das erste anorganische Material mindestens eines ist, das aus Bi₂Te₃, Bi₇Te₃, Bi₂Te, Bi₄Te₃, BiTe, Bi₆Te₇, Bi₄Te₅, BiₓTe_{y} (0 < x < 100, 0 < y < 100, 0 < x + y≤100), In₂Te₃, Ga₂Te₂, Al₂Te₃, TI₂Te₃, SnTe, PbTe, FlTe, AlInSb, AlGaSb, AlAsSb, GaAs, InSb, AlSb, AlAs, AlₐInₐSb (0 < a < 1), Al_{b}In_{(1-b)}Sb (0 < b < 1), AlSb, GaSb, und AlInGaAs ausgewählt ist.

5. Organische lichtemittierende Vorrichtung (10, 20, 30, 40) nach einem der Ansprüche 1 bis 4, wobei eine thermische Verdampfungstemperatur des ersten anorganischen Materials 1 500 °C oder weniger beträgt.

6. Organische lichtemittierende Vorrichtung (10, 20, 30, 40) nach einem der Ansprüche 1 bis 5, wobei die m-1 ladungserzeugenden Schichten vom n-Typ (155') ferner eine metallfreie Verbindung, die mindestens einen Stickstoff enthaltenden Ring mit π-Elektronenmangel umfasst, eine Verbindung, die durch Formel 601 dargestellt wird, ein Metalloxid, ein Metallcarbid, ein Metallhalogenid oder jegliche Mischung davon umfassen:
Formel 601 [Ar₆₀₁]ₓₑ₁₁-[(L₆₀₁)ₓₑ₁-R₆₀₁]ₓₑ₂₁,
wobei in Formel 601
Ar₆₀₁ eine substituierte oder unsubstituierte karbozyklische C₅-C₆₀-Gruppe oder eine substituierte oder unsubstituierte heterozyklische C₁-C₆₀-Gruppe ist,
xe11 1, 2 oder 3 ist,
L₆₀₁ ausgewählt ist aus einer substituierten oder unsubstituierten C₃-C₁₀-Cycloalkylengruppe, einer substituierten oder unsubstituierten C₁-C₁₀-Heterocycloalkylengruppe, einer substituierten oder unsubstituierten C₃-C₁₀-Cycloalkenylengruppe, einer substituierten oder unsubstituierten C₁-C₁₀-Heterocycloalkenylengruppe, einer substituierten oder unsubstituierten C₆-C₆₀-Arylengruppe, einer substituierten oder unsubstituierten C₁-C₆₀-Heteroarylengruppe, einer substituierten oder unsubstituierten zweiwertigen nichtaromatischen kondensierten polyzyklischen Gruppe und einer substituierten oder unsubstituierten zweiwertigen nichtaromatischen kondensierten heteropolyzyklischen Gruppe,
xe1 eine ganze Zahl von 0 bis 5 ist,
R₆₀₁ ausgewählt ist aus einer substituierten oder unsubstituierten C₃-C₁₀-Cycloalkylgruppe, einer substituierten oder unsubstituierten C₁-C₁₀-Heterocycloalkylgruppe, einer substituierten oder unsubstituierten C₃-C₁₀-Cycloalkenylgruppe, einer substituierten oder unsubstituierten C₁-C₁₀-Heterocycloalkenylgruppe, einer substituierten oder unsubstituierten C₆-C₆₀-Arylgruppe, einer substituierten oder unsubstituierten C₆-C₆₀-Aryloxygruppe, einer substituierten oder unsubstituierten C₆-C₆₀-Arylthiogruppe, einer substituierten oder unsubstituierten C₁-C₆₀-Heteroarylgruppe, einer substituierten oder unsubstituierten einwertigen nichtaromatischen kondensierten polyzyklischen Gruppe, einer substituierten oder unsubstituierten einwertigen nichtaromatischen kondensierten heteropolyzyklischen Gruppe, -Si(Q₆₀₁)(Q₆₀₂)(Q₆₀₃), -C(=O)(Q₆₀₁), -S(=O)₂(Q₆₀₁) und -P(=O)(Q₆₀₁)(Q₆₀₂),
Q₆₀₁ bis Q₆₀₃ jeweils unabhängig voneinander eine C₁-C₁₀-Alkylgruppe, eine C₁-C₁₀-Alkoxygruppe, eine Phenylgruppe, eine Biphenylgruppe, eine Terphenylgruppe oder eine Naphthylgruppe sind, und
xe21 eine ganze Zahl von 1 bis 5 ist.

7. Organische lichtemittierende Vorrichtung (10, 20, 30, 40) nach einem der Ansprüche 1 bis 6, wobei mindestens eine der m-1 ladungserzeugenden Schichten vom p-Typ (155'') das erste anorganische Material und ein Löchertransportmaterial umfasst, wobei optional eine Menge des ersten anorganischen Materials in der mindestens einen der m-1 ladungserzeugenden Schichten vom p-Typ (155'') in einem Bereich von 0,01 Gewichtsteilen bis 49,9 Gewichtsteilen ausgewählt ist, bezogen auf 100 Gewichtsteile des Löchertransportmaterials.

8. Organische lichtemittierende Vorrichtung (20) nach einem der Ansprüche 1 bis 7, wobei mindestens eine der m-1 ladungserzeugenden Schichten (155) ferner eine Zwischenschicht (155a) zwischen der ladungserzeugenden Schicht vom n-Typ (155') und der ladungserzeugenden Schicht vom p-Typ (155'') umfasst.

9. Organische lichtemittierende Vorrichtung (20) nach Anspruch 8, wobei die Zwischenschicht (155a) das erste anorganische Material umfasst, wobei optional mindestens eine der m-1 ladungserzeugenden Schichten vom n-Typ (155') und m-1 ladungserzeugenden Schichten vom p-Typ (155'') das erste anorganische Material umfasst, das sich vom ersten anorganischen Material in der Zwischenschicht (155a) unterscheidet.

10. Organische lichtemittierende Vorrichtung (10, 20, 30, 40) nach einem der Ansprüche 1 bis 9, ferner ein zweites anorganisches Material umfassend, das mindestens eines ist, das aus einer Halogenidverbindung eines Übergangsmetalls, einer Halogenidverbindung eines späten Übergangsmetalls und Kombinationen davon ausgewählt ist, wobei optional das zweite anorganische Material mindestens eines ist, das aus CuF, CuCl, CuBr, CuI, NiF₂, NiCl₂, NiBr₂, NiI₂, ZnF₂, ZnCl₂, ZnBr₂, ZnI₂, ZnF₄ und ZnI₄ ausgewählt ist.

11. Organische lichtemittierende Vorrichtung (10, 20, 30, 40) nach Anspruch 10, wobei das zweite anorganische Material in einem von Folgendem ist:
i) einer ladungserzeugenden Schicht aus der ladungserzeugenden Schicht vom n-Typ und der ladungserzeugenden Schicht vom p-Typ, die das erste anorganische Material umfasst;
ii) einer Hilfsschicht, die an die ladungserzeugende Schicht, welche das erste anorganische Material umfasst, angrenzt; oder
iii) der ladungserzeugenden Schicht, die das erste anorganische Material und die Hilfsschicht umfasst.

12. Organische lichtemittierende Vorrichtung (10, 20, 30, 40) nach einem der Ansprüche 1 bis 11, wobei m 2 oder 3 ist.

13. Flachanzeigeeinrichtung, Folgendes umfassend:
einen Dünnschichttransistor, der eine Source-Elektrode, eine Drain-Elektrode und eine Aktivierungsschicht umfasst; und
eine organische lichtemittierende Vorrichtung (10, 20, 30, 40) nach einem der Ansprüche 1 bis 12,
wobei die erste Elektrode (110) der organischen lichtemittierenden Vorrichtung mit einer aus der Source-Elektrode und der Drain-Elektrode des Dünnschichttransistors ausgewählten Elektrode elektrisch gekoppelt ist.

## Revendications

1. Dispositif électroluminescent organique (10, 20, 30, 40) comprenant :
une première électrode (110) ;
une seconde électrode (190) qui fait face à la première électrode (110) ;
m unités d'émission (153) entre la première électrode (110) et la seconde électrode (190), les m unités d'émission (153) comprenant au moins une couche d'émission ; et
m-1 couches de génération de charges (155) entre deux unités d'émission adjacentes parmi les m unités d'émission (153), chacune des m-1 couches de génération de charges (155) comprenant une couche de génération de charges de type n (155') et une couche de génération de charges de type p (155"),
dans lequel m est un entier de 2 ou plus,
au moins l'une des m-1 couches de génération de charges de type p (155") comprend un premier matériau inorganique, dans lequel le premier matériau inorganique est un composé comprenant un métal de post-transition et un métalloïde,
le métal de post-transition est au moins un métal sélectionné parmi l'aluminium (Al), le gallium (Ga), l'indium (In), le thallium (Tl), l'étain (Sn), le plomb (Pb), le flérovium (Fl), le bismuth (Bi) et le polonium (Po),
le métalloïde est au moins un métalloïde sélectionné parmi le bore (B), le silicium (Si), le germanium (Ge), l'arsenic (As), l'antimoine (Sb), le tellure (Te) et l'astatine (At), et
au moins l'une des m-1 couches de génération de charges de type n (155') inclut un métal.

2. Dispositif électroluminescent organique (10, 20, 30, 40) selon la revendication 1, dans lequel :
(i) un rapport de composition du métal de post-transition et du métalloïde est compris entre 50:1 et 1:50 ; et/ou
(ii) une valeur absolue d'un travail d'extraction du premier matériau inorganique est de 3,0 eV ou plus.

3. Dispositif électroluminescent organique (10, 20, 30, 40) selon la revendication 1 ou la revendication 2, dans lequel :
(i) le métal de post-transition est au moins un métal sélectionné parmi Al, Ga, In, Tl, Sn, Pb, Fl et Bi ; et/ou
(ii) le métalloïde est au moins un métalloïde sélectionné parmi Si, Ge, As, Sb et Te.

4. Dispositif électroluminescent organique (10, 20, 30, 40) selon l'une quelconque des revendications 1 à 3, dans lequel le premier matériau inorganique est au moins un matériau inorganique sélectionné parmi Bi₂Te₃, Bi₇Te₃, Bi₂Te, Bi₄Te₃, BiTe, Bi₆Te₇, Bi₄Te₅, BiₓTe_{y} (0 < x < 100, 0 < y < 100, 0 < x + y ≤ 100), In₂Te₃, Ga₂Te₂, Al₂Te₃, TI₂Te₃, SnTe, PbTe, FITe, AlInSb, AlGaSb, AlAsSb, GaAs, InSb, AlSb, AlAs, AlₐInₐSb (0 < a < 1), Al_{b}In₍₁-_{b)}Sb (0 < b < 1), AlSb, GaSb et AlInGaAs.

5. Dispositif électroluminescent organique (10, 20, 30, 40) selon l'une quelconque des revendications 1 à 4, dans lequel une température d'évaporation thermique du premier matériau inorganique est de 1 500 °C ou moins.

6. Dispositif électroluminescent organique (10, 20, 30, 40) selon l'une quelconque des revendications 1 à 5, dans lequel les m-1 couches de génération de charges de type n (155') comprennent en outre un composé exempt de métal comprenant au moins un cycle contenant de l'azote déficient en électrons π, un composé représenté par la Formule 601, un oxyde de métal, un carbure de métal, un halogénure de métal ou un quelconque mélange de ceux-ci :
Formule 601 [Ar₆₀₁]ₓₑ₁₁-[(L₆₀₁)ₓₑ₁-R₆₀₁]ₓₑ₂₁,
où, dans la Formule 601,
Ar₆₀₁ est un groupe C₅-C₆₀ carbocyclique substitué ou non substitué ou un groupe C₁-C₆₀ hétérocyclique substitué ou non substitué,
xe11 est 1, 2, ou 3,
L₆₀₁ est sélectionné parmi un groupe C₃-C₁₀ cycloalkylène substitué ou non substitué, un groupe C₁-C₁₀ hétérocycloalkylène substitué ou non substitué, un groupe C₃-C₁₀ cycloalkénylène substitué ou non substitué, un groupe C₁-C₁₀ hétérocycloalkénylène substitué ou non substitué, un groupe C₆-C₆₀ arylène substitué ou non substitué, un groupe C₁-C₆₀ hétéroarylène substitué ou non substitué, un groupe polycyclique condensé non aromatique divalent substitué ou non substitué et un groupe hétéropolycyclique condensé non aromatique divalent substitué ou non substitué,
xe1 est un entier de 0 à 5,
R₆₀₁ est sélectionné parmi un groupe C₃-C₁₀ cycloalkyle substitué ou non substitué, un groupe C₁-C₁₀ hétérocycloalkyle substitué ou non substitué, un groupe C₃-C₁₀ cycloalkényle substitué ou non substitué, un groupe C₁-C₁₀ hétérocycloalkényle substitué ou non substitué, un groupe C₆-C₆₀ aryle substitué ou non substitué, un groupe C₆-C₆₀ aryloxy substitué ou non substitué, un groupe C₆-C₆₀ arylthio substitué ou non substitué, un groupe C₁-C₆₀ hétéroaryle substitué ou non substitué, un groupe polycyclique condensé non aromatique monovalent substitué ou non substitué, un groupe hétéropolycyclique condensé non aromatique monovalent substitué ou non substitué, -Si(Q₆₀₁)(Q₆₀₂)(Q₆₀₃), -C(=O)(Q₆₀₁), -S(=O)₂(Q₆₀₁) et -P(=O)(Q₆₀₁)(Q₆₀₂),
Q₆₀₁ à Q₆₀₃ sont chacun de manière indépendante un groupe C₁-C₁₀ alkyle, un groupe C₁-C₁₀ alcoxy, un groupe phényle, un groupe biphényle, un groupe terphényle ou un groupe naphtyle, et
xe21 est un entier de 1 à 5.

7. Dispositif électroluminescent organique (10, 20, 30, 40) selon l'une quelconque des revendications 1 à 6, dans lequel au moins l'une des m-1 couches de génération de charges de type p (155'') comprend le premier matériau inorganique et un matériau de transport de trous, optionnellement dans lequel une quantité du premier matériau inorganique dans l'au moins une des m-1 couches de génération de charges de type p (155'') est sélectionnée dans une plage de 0,01 partie en poids à 49,9 parties en poids, sur la base de 100 parties en poids du matériau de transport de trous.

8. Dispositif électroluminescent organique (20) selon l'une quelconque des revendications 1 à 7, dans lequel au moins l'une des m-1 couches de génération de charges (155) comprend en outre une intercouche (155a) entre la couche de génération de charges de type n (155') et la couche de génération de charges de type p (155'').

9. Dispositif électroluminescent organique (20) selon la revendication 8, dans lequel l'intercouche (155a) comprend le premier matériau inorganique, optionnellement dans lequel au moins l'une des m-1 couches de génération de charges de type n (155') et des m-1 couches de génération de charges de type p (155'') comprend le premier matériau inorganique qui est différent du premier matériau inorganique dans l'intercouche (155a).

10. Dispositif électroluminescent organique (10, 20, 30, 40) selon l'une quelconque des revendications 1 à 9, comprenant en outre un second matériau inorganique qui est au moins un matériau sélectionné parmi un composée halogénure d'un métal de transition, un composé halogénure d'un métal de transition tardif et des combinaisons de ceux-ci, optionnellement dans lequel le second matériau inorganique est au moins un matériau sélectionné parmi CuF, CuCI, CuBr, CuI, NiF₂, NiCl₂, NiBr₂, NiI₂, ZnF₂, ZnCl₂, ZnBr₂, ZnI₂, ZnF₄ et ZnI₄.

11. Dispositif électroluminescent organique (10, 20, 30, 40) selon la revendication 10, dans lequel le second matériau inorganique est dans :
i) une couche de génération de charges parmi la couche de génération de charges de type n et la couche de génération de charges de type p qui comprend le premier matériau inorganique ;
ii) une couche auxiliaire adjacente à la couche de génération de charges qui comprend le premier matériau inorganique ; ou
iii) la couche de génération de charges qui comprend le premier matériau inorganique et la couche auxiliaire.

12. Dispositif électroluminescent organique (10, 20, 30, 40) selon l'une quelconque des revendications 1 à 11, dans lequel m est 2 ou 3.

13. Appareil à écran plat comprenant :
un transistor à film mince comprenant une électrode de source, une électrode de drain et une couche d'activation ; et
un dispositif électroluminescent organique (10, 20, 30, 40) selon l'une quelconque des revendications 1 à 12,
dans lequel la première électrode (110) du dispositif électroluminescent organique est couplée électriquement à une électrode sélectionnée parmi l'électrode de source et l'électrode de drain du transistor à film mince.
